# EUROPEAN PATENT APPLICATION

(11) **EP 4 386 848 A1**
(43) Date of publication of application: **19.06.2024**
(21) Application number: 22855900.1
(22) Date of filing: 10.08.2022
(51) Int. Cl.: H01L 27/146, G02B 3/02, H04N 25/70

(54) **IMAGING DEVICE AND ELECTRONIC APPARATUS**

(30) Priority: 13.08.2021 JP 2021132025
(71) Applicant: Sony Semiconductor Solutions Corporation, Atsugi-shi, Kanagawa 243-0014 (JP)
(72) Inventor: GOI, Kazuhiro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/030558
(87) International publication number: WO 2023/017838

(57) **Abstract**

An imaging apparatus that reduces the influence of light condensing shift is provided even in a case where the position of the on-chip lens of pixels or the like varies. The imaging apparatus according to the present disclosure includes a plurality of pixels and an on-chip lens. The pixel included in the imaging apparatus performs photoelectric conversion of incident light from a subject to generate an image signal. The on-chip lens included in the imaging apparatus is arranged in common in the plurality of pixels, includes the non-condensing region in the central portion, and condenses the incident light on the plurality of pixels in the peripheral portion.

## Description

### Field

The present disclosure relates to an imaging apparatus and an electronic device. Specifically, the present disclosure relates to an imaging apparatus and an electronic device including the imaging apparatus.

### Background

As an imaging apparatus that images a subject, an imaging apparatus in which pixels including photoelectric conversion elements that perform photoelectric conversion of incident light are arranged in a two-dimensional matrix is used. In order to improve the sensitivity of the imaging apparatus, an on-chip lens is arranged in the pixel. The on-chip lens is, for example, a lens that is formed in a hemispherical shape and condenses incident light of a pixel on a photoelectric conversion element. On the other hand, an imaging lens that forms an image of a subject is disposed outside the imaging apparatus. The imaging apparatus is irradiated with the incident light transmitted through the imaging lens. At this time, light from the subject obliquely enters the pixels arranged in the peripheral edge portion of the imaging apparatus. For this reason, in the pixel in the peripheral edge portion, the light condensing position by the on-chip lens deviates from the photoelectric conversion element, and the sensitivity decreases. This phenomenon is referred to as shading.

Therefore, an imaging apparatus (solid-state imaging apparatus) including an on-chip lens having a lens curved surface for correcting the shading has been proposed (see, for example, Patent Literature 1.). In this imaging apparatus, shading is reduced by arranging an on-chip lens having a lens curved surface in which an inclination component is superimposed on a spherical surface.

### Citation List

### Patent Literature

Patent Literature 1: JP 2006-156515 A

### Summary

### Technical Problem

However, in the above-described conventional technique, there is a problem that it is difficult to correct the light condensing position in a case where the position or the like of the on-chip lens varies. This is a significant problem in a pixel that generates a phase difference signal for detecting an image plane phase difference of a subject in order to perform autofocus. This pixel is a pixel that pupil-divides a subject, and has a configuration in which an on-chip lens is arranged in common in a plurality of pixels. The common on-chip lens irradiates a plurality of pixels with light from a subject in common to perform pupil division, and a phase difference signal is generated by comparing signals between the pixels. The focal position of the subject is detected by the phase difference signal. When the light condensing shift occurs in such a phase difference pixel, an error is included in the detected image plane phase difference, and it becomes difficult to detect the focal position of the subject.

Therefore, the present disclosure proposes an imaging apparatus and an electronic device that reduce the influence of light condensing shift even in a case where the position of the on-chip lens or the like varies.

### Solution to Problem

An imaging apparatus according to the present disclosure includes: a plurality of pixels that performs photoelectric conversion of incident light from a subject to generate an image signal; and an on-chip lens that is arranged in common in the plurality of pixels, includes a non-condensing region in a central portion, and condenses the incident light on the plurality of pixels in a peripheral portion.

### Brief Description of Drawings

FIG. 1 is a diagram depicting a configuration example of an imaging apparatus according to an embodiment of the present disclosure.
FIG. 2 is a diagram depicting a configuration example of a pixel according to a first embodiment of the present disclosure.
FIG. 3 is a sectional view depicting a configuration example of a pixel according to the first embodiment of the present disclosure.
FIG. 4A is a view depicting an example of condensing of incident light in the pixel according to the first embodiment of the present disclosure.
FIG. 4B is a view depicting another example of condensing of incident light in the pixel according to the first embodiment of the present disclosure.
FIG. 5 is a plan view depicting an example of condensing of incident light in the pixel according to the first embodiment of the present disclosure.
FIG. 6A is a diagram depicting an arrangement example of pixel blocks according to the first embodiment of the present disclosure.
FIG. 6B is a diagram depicting another arrangement example of the pixel block according to the first embodiment of the present disclosure.
FIG. 7A is a view depicting an example of a method for manufacturing an on-chip lens according to an embodiment of the present disclosure.
FIG. 7B is a view depicting an example of a method for manufacturing an on-chip lens according to an embodiment of the present disclosure.
FIG. 7C is a view depicting an example of a method for manufacturing an on-chip lens according to an embodiment of the present disclosure.
FIG. 7D is a view depicting an example of a method for manufacturing an on-chip lens according to an embodiment of the present disclosure.
FIG. 8 is a diagram depicting a configuration example of a resist used for on-chip lens formation according to an embodiment of the present disclosure.
FIG. 9 is a diagram depicting a configuration example of a pixel according to a first modification of the first embodiment of the present disclosure.
FIG. 10 is a diagram depicting a configuration example of a pixel according to a second modification of the first embodiment of the present disclosure.
FIG. 11 is a diagram depicting a configuration example of a pixel according to the second embodiment of the present disclosure.
FIG. 12 is a diagram depicting a configuration example of a pixel according to a third embodiment of the present disclosure.
FIG. 13 is a diagram depicting another configuration example of a pixel according to the third embodiment of the present disclosure.
FIG. 14A is a diagram depicting a configuration example of a pixel according to a fourth embodiment of the present disclosure.
FIG. 14B is a diagram depicting a configuration example of an on-chip lens according to the fourth embodiment of the present disclosure.
FIG. 14C is a diagram depicting a configuration example of the on-chip lens according to the fourth embodiment of the present disclosure.
FIG. 14D is a diagram depicting a configuration example of the on-chip lens according to the fourth embodiment of the present disclosure.
FIG. 15 is a diagram depicting an arrangement example of a pixel block according to the fourth embodiment of the present disclosure.
FIG. 16 is a diagram depicting another arrangement example of the pixel block according to the fourth embodiment of the present disclosure.
FIG. 17 is a diagram depicting another arrangement example of the pixel block according to the fourth embodiment of the present disclosure.
FIG. 18 is a diagram depicting a configuration example of a pixel block according to a fifth embodiment of the present disclosure.
FIG. 19A is a diagram depicting another configuration example of the pixel block according to the fifth embodiment of the present disclosure.
FIG. 19B is a diagram depicting a configuration example of an on-chip lens according to the fifth embodiment of the present disclosure.
FIG. 19C is a diagram depicting a configuration example of the on-chip lens according to the fifth embodiment of the present disclosure.
FIG. 20 is a diagram depicting an arrangement example of the pixel block according to the fifth embodiment of the present disclosure.
FIG. 21 is a diagram depicting another arrangement example of the pixel block according to the fifth embodiment of the present disclosure.
FIG. 22 is a diagram depicting a configuration example of a pixel unit according to a sixth embodiment of the present disclosure.
FIG. 23 is a diagram depicting another configuration example of the pixel unit according to the sixth embodiment of the present disclosure.
FIG. 24 is a diagram depicting another configuration example of the pixel unit according to the sixth embodiment of the present disclosure.
FIG. 25 is a diagram depicting another configuration example of the pixel unit according to the sixth embodiment of the present disclosure.
FIG. 26 is a diagram depicting a configuration example of a pixel block according to a seventh embodiment of the present disclosure.
FIG. 27 is a diagram depicting another configuration example of the pixel block according to the seventh embodiment of the present disclosure.
FIG. 28 is a diagram depicting a configuration example of a pixel block according to an eighth embodiment of the present disclosure.
FIG. 29 is a diagram depicting a configuration example of a pixel according to a ninth embodiment of the present disclosure.
FIG. 30A is a diagram depicting a configuration example of a pixel according to the ninth embodiment of the present disclosure.
FIG. 30B is a diagram depicting a configuration example of a pixel according to the ninth embodiment of the present disclosure.
FIG. 31 is a diagram depicting a configuration example of a pixel block according to a tenth embodiment of the present disclosure.
FIG. 32A is a diagram depicting a configuration example of the on-chip lens according to the tenth embodiment of the present disclosure.
FIG. 32B is a diagram depicting a configuration example of an on-chip lens according to the tenth embodiment of the present disclosure.
FIG. 32C is a diagram depicting a configuration example of the on-chip lens according to the tenth embodiment of the present disclosure.
FIG. 33 is a diagram depicting another configuration example of the pixel block according to the tenth embodiment of the present disclosure.
FIG. 34 is a diagram depicting another configuration example of the pixel block according to the tenth embodiment of the present disclosure.
FIG. 35 is a diagram depicting another configuration example of the pixel block according to the tenth embodiment of the present disclosure.
FIG. 36A is a diagram depicting a configuration example of the on-chip lens according to the tenth embodiment of the present disclosure.
FIG. 36B is a diagram depicting a configuration example of the on-chip lens according to the tenth embodiment of the present disclosure.
FIG. 37 is a block diagram depicting a configuration example of an imaging apparatus mounted on an electronic device.
FIG. 38 is a block diagram depicting a schematic configuration example of a vehicle control system which is an example of a mobile body control system to which the technology according to the present disclosure can be applied.
FIG. 39 is a diagram depicting an example of an installation position of an imaging section.
FIG. 40 is a view depicting an example of a schematic configuration of an endoscopic surgery system to which the technology according to an embodiment of the present disclosure (present technology) can be applied.
FIG. 41 is a block diagram depicting an example of a functional configuration of the camera head and the CCU depicted in FIG. 40.

### Description of Embodiments

Hereinafter, embodiments of the present disclosure will be described in detail with reference to the drawings. The description will be given in the following order. In each of the following embodiments, the same parts are denoted by the same reference numerals, and redundant description will be omitted.
1. First Embodiment
2. Second Embodiment
3. Third Embodiment
4. Fourth embodiment
5. Fifth Embodiment
6. Sixth Embodiment
7. Seventh Embodiment
8. Eighth Embodiment
9. Ninth Embodiment
10. Tenth Embodiment
11. Eleventh Embodiment
12. Configuration Example of Imaging Apparatus
13. Application Example to Mobile Body
14. Application Example to Endoscopic Surgery System

### (1. First Embodiment)

### [Configuration of Image Pickup Element]

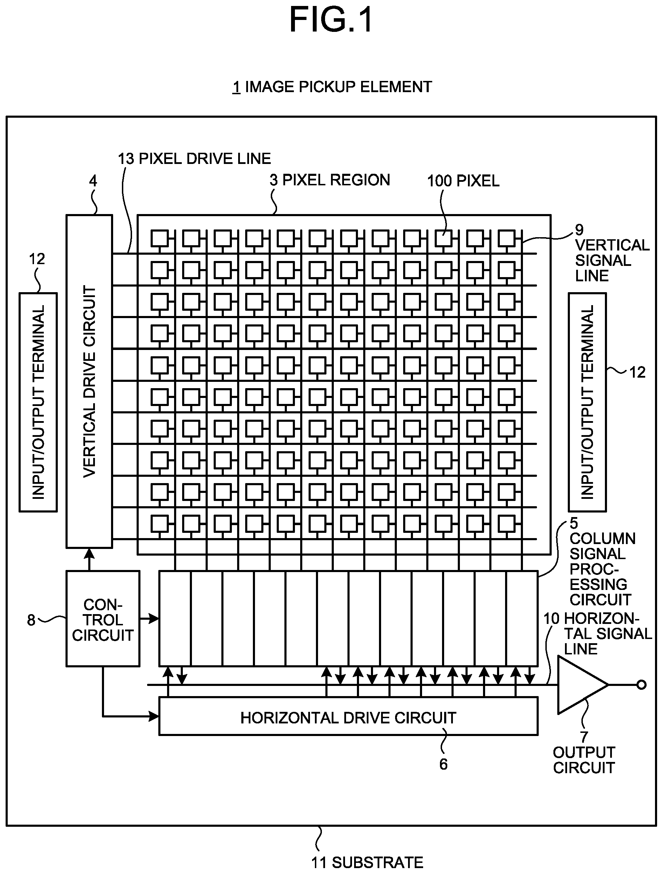

FIG. 1 is a diagram depicting a configuration example of an imaging apparatus according to the embodiment of the present disclosure. As depicted in FIG. 1, the imaging apparatus 1 of the present example includes a pixel region (so-called imaging region) 3 in which pixels 100 including a plurality of photoelectric conversion elements are regularly and two-dimensionally arrayed on a semiconductor substrate 11, for example, a silicon substrate, and a peripheral circuit unit. The pixels 100 includes, for example, a photodiode serving as a photoelectric conversion element and a plurality of pixel transistors (so-called MOS transistors). The plurality of pixel transistors includes, for example, three transistors: a transfer transistor, a reset transistor, and an amplification transistor. In addition, a selection transistor may be added to configure the pixel transistor with four transistors. The pixels 100 may have a shared pixel structure. This pixel sharing structure includes a plurality of photodiodes, a plurality of transfer transistors, one shared floating diffusion region, and each one of other shared pixel transistors.

The peripheral circuit unit includes a vertical drive circuit 4, column signal processing circuits 5, a horizontal drive circuit 6, an output circuit 7, and a control circuit 8, and the like.

The control circuit 8 receives an input clock and data instructing an operation mode and the like, and outputs data such as internal information of the image pickup element. That is, in the control circuit 8, a clock signal or a control signal serving as a reference of operations of the vertical drive circuit 4, the column signal processing circuit 5, the horizontal drive circuit 6, and the like is generated on the basis of the vertical synchronization signal, the horizontal synchronization signal, and the master clock. Then, these signals are input to the vertical drive circuit 4, the column signal processing circuits 5, the horizontal drive circuit 6, and the like.

The vertical drive circuit 4 includes, for example, a shift register, selects a pixel drive line 13, supplies a pulse for driving the pixels to the selected pixel drive line, and drives the pixels in units of rows. That is, the vertical drive circuit 4 sequentially selects and scans each of the pixels 100 in the pixel region 3 in the vertical direction in units of rows, and supplies a pixel signal based on a signal charge generated according to the amount of received light in, for example, a photodiode serving as a photoelectric conversion element of each of the pixels 100 to the column signal processing circuits 5 through the vertical signal line 9.

The column signal processing circuit 5 is arranged, for example, for each column of the pixels 100, and performs signal processing such as noise removal on the signals output from the pixels 100 of one row for each pixel column. That is, the column signal processing circuits 5 performs signal processing such as correlated double sampling (CDS) for removing fixed pattern noise unique to the pixels 100, signal amplification, and AD conversion. In the output stage of the column signal processing circuits 5, a horizontal selection switch (not illustrated) is connected and provided between the column signal processing circuit and a horizontal signal line 10. Note that the column signal processing circuit 5 is an example of a processing circuit described in the claims.

The horizontal drive circuit 6 includes, for example, a shift register, sequentially selects each of the column signal processing circuits 5 by sequentially outputting horizontal scanning pulses, and causes each of the column signal processing circuits 5 to output a pixel signal to the horizontal signal line 10.

The output circuit 7 performs signal processing on the signals sequentially supplied from each of the column signal processing circuits 5 through the horizontal signal line 10, and outputs the processed signals. For example, only buffering may be performed, or black level adjustment, column variation correction, various digital signal processing, and the like may be performed. An input/output terminal 12 exchanges signals externally.

### [Configuration of Image Pickup Element]

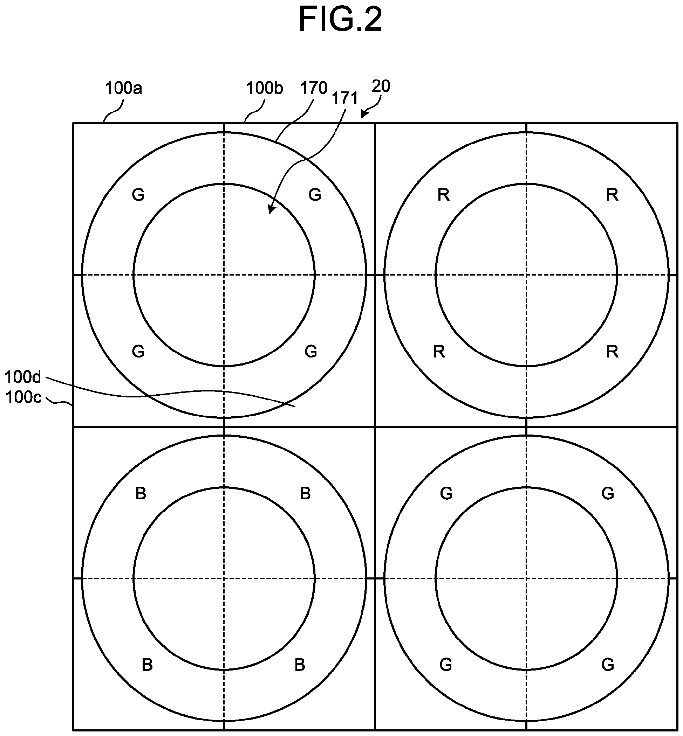

FIG. 2 is a diagram depicting a configuration example of the pixel according to the first embodiment of the present disclosure. The drawing is a plan view depicting a configuration example of the pixels 100. As described above, the pixels 100 are arrayed in the pixel region 3. The drawing depicts an example in which the pixels 100 are arrayed in a two-dimensional matrix. Note that "R", "G", and "B" attached to the pixels 100 in the drawing represent the types of color filters 150 to be described later. In the drawing, "R", "G", and "B" represent the color filters 150 corresponding to red light, green light, and blue light, respectively.

Furthermore, an on-chip lens 170 is arranged in the pixels 100. The on-chip lens 170 condenses incident light on the photoelectric conversion element of the pixel 100, and is arranged in common in the plurality of pixels 100. The drawing depicts an example in which the on-chip lens 170 is arranged in common in the four pixels 100 (a pixel 100a, a pixel 100b, a pixel 100c, and a pixel 100d in the drawing) arranged in 2 rows and 2 columns. Furthermore, the on-chip lens 170 in the drawing is arranged in common in the four pixels 100 in which the color filters 150 of the same color are arranged. The drawing depicts an example in which a pixel block 20 corresponding to red light, green light, and blue light are arranged in a Bayer array.

The drawing depicts an example in which the on-chip lens 170 is formed in a circular shape in plan view. Furthermore, the on-chip lens 170 can be configured to have
a substantially hemispherical cross section having a non-condensing region 171 in the central portion thereof. The non-condensing region 171 can be configured by, for example, a concave portion having a recessed surface. The on-chip lens 170 condenses the incident light on the photoelectric conversion element in a peripheral portion other than the non-condensing region 171. The plurality of pixels 100 in which the on-chip lens 170 and the on-chip lens 170 are arranged in common constitutes the pixel block 20.

### [Configuration of Cross-Section of Image Pickup Element]

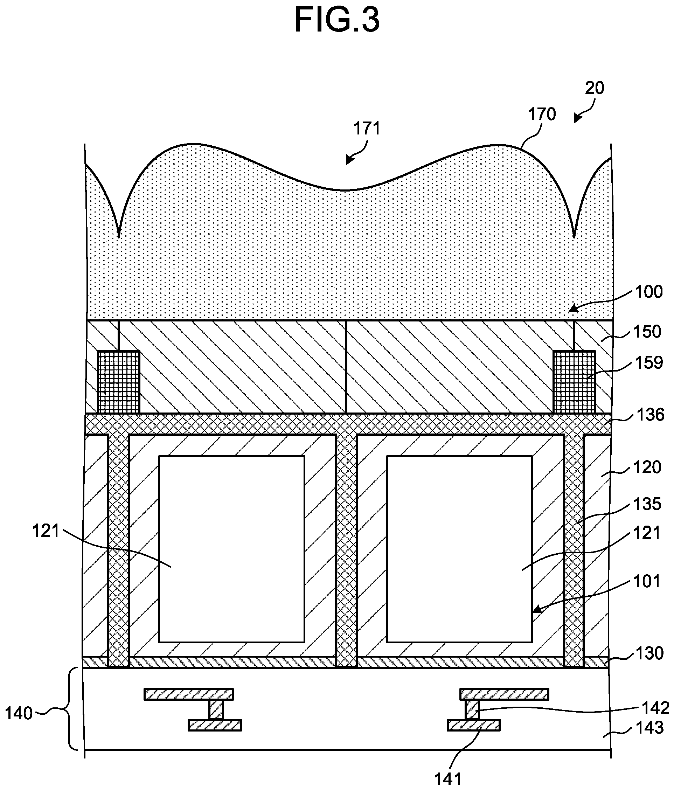

FIG. 3 is a sectional view depicting a configuration example of the pixel according to the first embodiment of the present disclosure. The drawing is a cross-sectional view illustrating a configuration example of the pixel 100. Furthermore, the pixel 100 in the drawing is a pixel 100 included in the pixel block 20 in which the on-chip lens 170 is arranged in common. The pixel 100 includes a semiconductor substrate 120, an insulating film 130, a wiring region 140, an isolation section 135, a protective film 136, and a color filter 150.

The semiconductor substrate 120 is a semiconductor substrate on which the diffusion layer of the semiconductor element of the pixel 100 is disposed. The semiconductor substrate 120 can be made of, for example, silicon (Si). The semiconductor element and the like are arranged in a well region formed in the semiconductor substrate 120. For convenience, the semiconductor substrate 120 in the drawing is assumed to be configured in a p-type well region. A semiconductor element can be formed by disposing an n-type or p-type semiconductor region in the p-type well region. A photoelectric conversion element 101 is illustrated as an example in the semiconductor substrate 120 in the drawing. The photoelectric conversion element 101 includes an n-type semiconductor region 121. Specifically, a photodiode including a p-n junction at an interface between the n-type semiconductor region 121 and a surrounding p-type well region corresponds to the photoelectric conversion element 101.

The insulating film 130 insulates the front surface side of the semiconductor substrate 120. For example, a film of silicon oxide (SiO₂) can be applied to the insulating film 130.

The wiring region 140 is a region in which wiring of an element is formed, being disposed on the front surface side of the semiconductor substrate 120. The wiring region 140 includes a wiring 141, a via plug 142, and an insulating layer 143. The wiring 141 is a conductor that transmits a signal to an element or the like of the semiconductor substrate 120. The wiring 141 can be made of, for example, a metal such as copper (Cu) or tungsten (W). The via plug 142 connects the wirings 141 arranged in different layers. The via plug 142 can be made of, for example, a columnar metal. The insulating layer 143 insulates the wiring 141 and the like. The insulating layer 143 can be made of, for example, SiO₂.

The isolation section 135 is arranged at a boundary of the pixel 100 in the semiconductor substrate 120 to electrically and optically separate the pixel 100. The isolation section 135 can be formed of an insulator embedded in the semiconductor substrate 120. The isolation section 135 can be formed, for example, by disposing an insulator such as SiO₂ in a groove portion penetrating the semiconductor substrate 120 formed at the boundary of the pixel 100. Note that the isolation section 135 can also be configured to have a depth not reaching the front surface side from the back surface side of the semiconductor substrate 120.

The protective film 136 is a film that protects the back surface side of the semiconductor substrate 120. The protective film 136 can be made of an insulator such as SiO₂. The protective film 136 in the drawing can be formed simultaneously with the isolation section 135. In addition, the protective film 136 and the isolation section 135 can be formed individually.

The color filter 150 is an optical filter that transmits incident light having a predetermined wavelength among the incident light. As the color filter 150, for example, a color filter that transmits red light, green light, and blue light can be used. In this case, one color filter 150 corresponding to any of red light, green light, and blue light is arranged in the pixel 100. The pixel 100 generates an image signal of incident light having a wavelength to which the color filter 150 corresponds. As described above, the color filters 150 of the same type are arranged in the plurality of pixels 100 arranged in the pixel block 20. The color filter 150 in the drawing is disposed on the back surface side of the semiconductor substrate 120.

Note that, in the pixel 100 in the drawing, a light shielding film 159 is arranged in the region of the color filter 150 at the boundary of the pixel block 20. The light shielding film 159 shields incident light. By disposing the light shielding film 159, it is possible to shield incident light obliquely incident from the adjacent pixel 100. Since the light shielding film 159 shields the incident light transmitted through the different types of color filters 150 of the pixel 100 of the adjacent pixel block 20, color mixture can be prevented, and deterioration in image quality can be prevented.

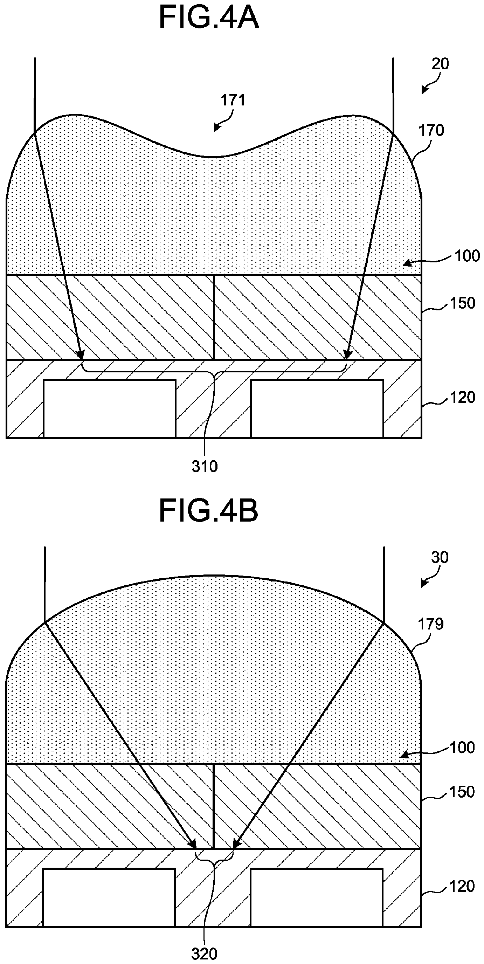

The on-chip lens 170 is a lens arranged in common in the plurality of pixels 100 constituting the pixel block 20 as described above. The on-chip lens 170 in the drawing includes a non-condensing region 171 configured by a concave portion in a central portion. A normal on-chip lens is configured to have a substantially hemispherical cross section as described later in FIG. 4B, and condenses incident light on a central portion in a plan view of the semiconductor substrate 120. On the other hand, the on-chip lens 170 in the drawing condenses the incident light on the central portion in the plan view of the semiconductor substrate 120 in the peripheral portion of the non-condensing region 171. On the other hand, the non-condensing region 171 transmits the incident light without condensing the incident light. Therefore, a relatively wide region of the semiconductor substrate 120 is irradiated with the incident light. The on-chip lens 170 can be made of an organic material such as an acrylic resin or an inorganic material such as silicon nitride (SiN).

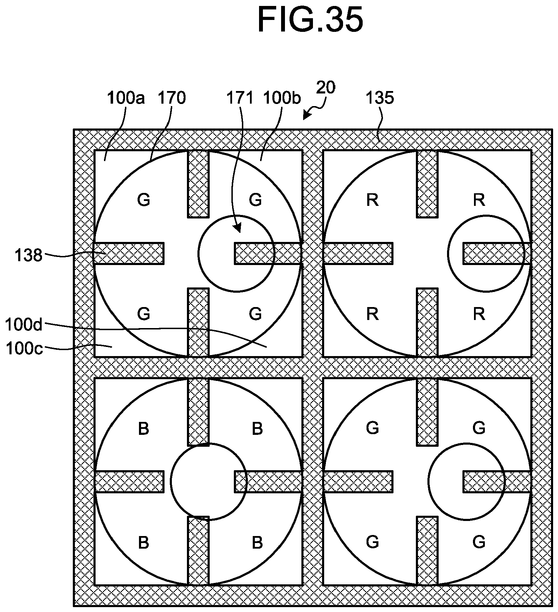

The pixels 100 of the pixel block 20 may be used as phase difference pixels. As will be described later with reference to FIG. 35, light transmitted through an imaging lens 702 is incident to the pixel block 20. The phase difference pixel is a pixel that generates a phase difference signal for detecting the focal position of the imaging lens 702. The phase difference pixel is a pixel that pupil-divides the subject as described above. By the common on-chip lens 170, light from the subject transmitted through the imaging lens 702 is commonly emitted to two adjacent phase difference pixels, and pupil division is performed. The light transmitted through the left side of the imaging lens 702 is incident on the pixel 100 on the right side in the drawing, and the light transmitted through the right side of the imaging lens 702 is incident on the pixel 100 on the left side in the drawing. Using the phase difference signals of the pixels 100 of the plurality of pixel blocks 20, images of the subject are generated by a plurality of phase difference signals based on the light transmitted through the left side of the imaging lens 702 and a plurality of phase difference signals based on the light transmitted through the right side of the imaging lens 702. The focal position of the subject can be detected based on the phase difference between these two images.

Note that the phase difference pixel can include a pair of pixels 100 among the four pixels 100 in FIG. 2. In the case of pupil division in the vertical direction of FIG. 2, the pixel 100a and the pixel 100c, and the pixel 100b and the pixel 100d are used as phase difference pixels, respectively. In addition, in the case of pupil division in the lateral direction of FIG. 2, the pixel 100a and the pixel 100b, and the pixel 100c and the pixel 100d are used as phase difference pixels, respectively.

### [Condensation of Incident Light]

FIG. 4A is a view depicting an example of condensing of incident light in the pixel according to the first embodiment of the present disclosure. The drawing is a diagram in which the pixel block 20 described in FIG. 3 is simplified. Arrows in the drawing represent arrival of incident light. Since the on-chip lens 170 has the non-condensing region 171, the incident light is condensed on a relatively wide region of the semiconductor substrate 120. A light condensing range 310 in the drawing represents a range in which the incident light is condensed by the on-chip lens 170. Note that, in a case where the size of the pixel 100 is as fine as the wavelength of the incident light, the waviness of the light becomes dominant. Therefore, the incident light is also distributed in the region of the end portion of the pixel 100. Even in this case, the incident light is condensed on a relatively wide region of the semiconductor substrate 120 by the non-condensing region 171.

FIG. 4B is a view depicting another example of condensing of incident light in the pixel according to the first embodiment of the present disclosure. The drawing depicts condensing of incident light on a second pixel block 30 in which a second on-chip lens 179 configured in a hemispherical cross section is arranged in common in the plurality of pixels 100. Since the non-condensing region 171 is not arranged in the second on-chip lens 179, a relatively narrow light condensing range 320 is obtained in the second pixel block 30. Therefore, in the second pixel block 30, the phase difference signal can be generated at a high isolation ratio. Note that the second pixel block 30 in the drawing can also be arranged in the pixel region 3.

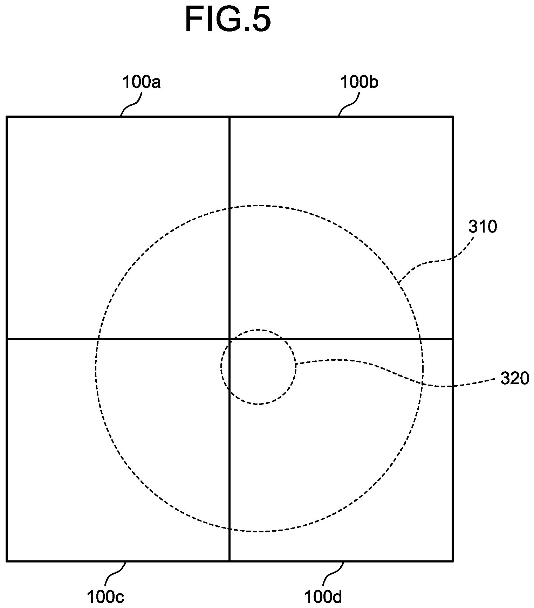

FIG. 5 is a plan view depicting an example of condensing of incident light in the pixel according to the first embodiment of the present disclosure. The drawing is a diagram for explaining light condensing ranges of the pixel block 20 and the second pixel block 30. Note that the drawing depicts an example of a case where the on-chip lens 170 and the second on-chip lens 179 are arranged to be shifted to the lower right of the drawing. The centers of the light condensing range 310 of the on-chip lens 170 and the light condensing range 320 of the second on-chip lens 179 are arranged to be shifted to the lower right of the drawing. Therefore, the amount of incident light on the pixels 100a, 100b, 100c, and 100d changes.

In the second pixel block 30 including the second on-chip lens 179, since the light condensing range 320 is relatively narrow, a significant difference occurs in the amount of incident light on the pixels 100a, 100b, 100c, and 100d. Specifically, the amount of incident light on the pixel 100a becomes substantially zero, and most of the incident light is condensed on the pixel 100d.

On the other hand, in the pixel block 20 including the on-chip lens 170, the light condensing range 310 is a relatively wide. The difference in the amount of incident light on the pixels 100a, 100b, 100c, and 100d can be reduced. Furthermore, also in a case where the pixels 100a, 100b, 100c, and 100d are used as phase difference pixels, errors included in the detected phase difference can be reduced.

### [Arrangement of Pixel Blocks]

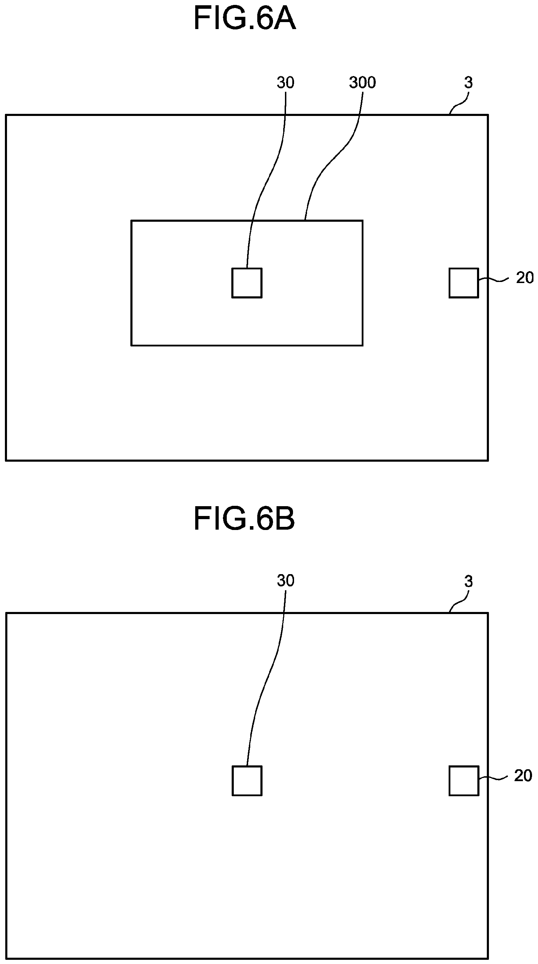

FIG. 6A is a diagram depicting an arrangement example of pixel blocks according to the first embodiment of the present disclosure. The drawing is a plan view depicting an arrangement example of the pixel block 20 and the second pixel block 30 in the pixel region 3. In the pixel region 3 in the drawing, a pixel block region 300 is arranged in the central portion. The second pixel block 30 is arranged in the pixel block region 300. The pixel block 20 is arranged in an external region of the pixel block region 300. In the central portion of the pixel region 3, incident light is incident substantially vertically. Therefore, the second pixel block 30 is arranged in the central portion of the pixel region 3. Since the light condensing range 320 is relatively narrow, the phase difference isolation ratio can be improved, and the phase difference detection accuracy can be improved.

In the pixel 100 in the central portion, the influence of the variation in the height of the on-chip lens 170 is reduced. This is because the incident light is incident substantially vertically, so that the shift in the horizontal direction is small. On the other hand, in the peripheral edge portion of the pixel region 3, the influence of the height variation of the on-chip lens 170 increases. This is because the incident positional shift in the horizontal direction increases.

The positional shift due to the oblique incident light in the peripheral edge portion having the high image height can be corrected by pupil correction. However, positional shift due to variations (manufacturing variations) in the height and the like of the on-chip lens 170 cannot be corrected by pupil correction. Therefore, by widening the condensing region, the influence of manufacturing variations of the on-chip lens 170 is reduced. As a result, the sensitivity difference between the pixels 100 of the pixel block 20 can be reduced.

### [Another Arrangement of Pixel Blocks]

FIG. 6B is a diagram depicting another arrangement example of the pixel block according to the first embodiment of the present disclosure. Similarly to FIG. 6A, the drawing is a plan view depicting an arrangement example of the pixel block 20 and the second pixel block 30 in the pixel region 3. In the drawing, the second pixel block 30 is arranged at the center of the pixel region 3, and the pixel block 20 is arranged in the other region. The arranged pixel block 20 adjusts the light condensing range 310 of the on-chip lens 170 according to the distance from the center. Specifically, the on-chip lens 170 of the pixel block 20 in the region close to the central portion of the pixel region 3 narrows the light condensing range 310. Then, the light condensing range 310 of the on-chip lens 170 is continuously widened as the distance from the central portion of the pixel region 3 increases. This can be performed by adjusting the opening of the concave portion constituting the non-condensing region 171 according to the incident angle of the incident light.

The adjustment of the opening of the concave portion corresponds to, for example, adjustment of the size and position of the opening. By adjusting at least one of the size and the position of the opening, the opening of the concave portion can be adjusted.

The adjustment of the light condensing range 310 can be performed, for example, by adjusting the range of the non-condensing region 171. Specifically, the pixel block 20 in the region close to the central portion of the pixel region 3 narrows the non-condensing region 171 of the on-chip lens 170. On the other hand, in the pixel block 20 in the peripheral edge portion of the pixel region 3, the non-condensing region 171 of the on-chip lens 170 is widened. In this manner, the size of the on-chip lens 170 non-condensing region 171 is adjusted according to the distance from the center of the pixel region 3. As a result, in the pixel block 20, the on-chip lens 170 of the light condensing range 310 according to the incident angle of the incident light can be arranged.

### [Method for Manufacturing On-Chip Lens]

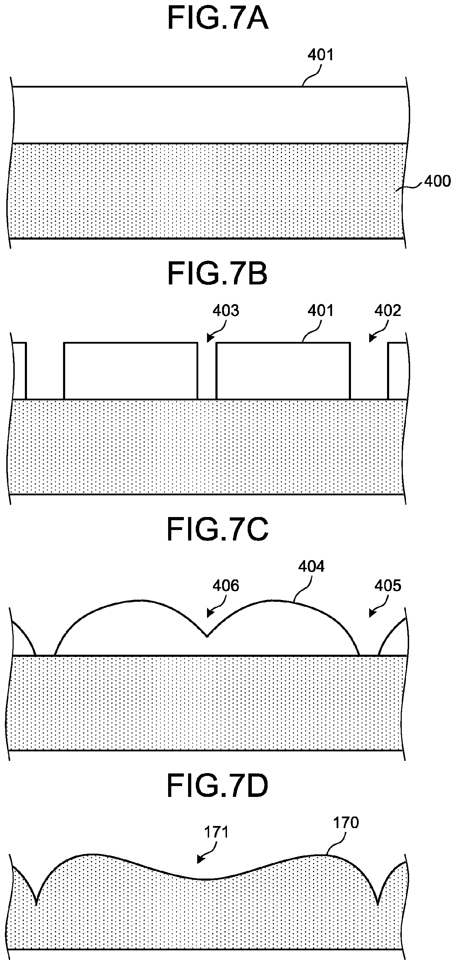

FIGS. 7A to 7D are views depicting an example of a method for manufacturing an on-chip lens according to an embodiment of the present disclosure. The drawing is a diagram depicting a manufacturing process of the on-chip lens 170. First, a material film 400 of the on-chip lens 170 is formed on the surface of the color filter 150 (not illustrated) stacked on the semiconductor substrate 120. Next, a resist 401 is disposed on the surface of the material film 400 (FIG. 7A). These can be performed by, for example, a coating method.

Next, openings 402 and 403 are formed in the resist 401. The opening 402 is a groove-shaped opening arranged at a boundary of the pixel block 20. The opening 403 is an opening disposed in a central portion of the pixel block 20 (FIG. 7B). The openings 402 and 403 can be formed by exposing and developing the resist 401.

Next, the resist 401 is processed into a shape of a lens. This can be performed by heating and softening the resist 401 (FIG. 7C) .

Next, the shape of the resist 401 is transferred to the material film 400 (FIG. 7D). This can be performed, for example, by etching the material film 400 using the resist 401 as a mask. Dry etching can be applied to this etching.

Through the above steps, the on-chip lens 170 can be formed. Next, the shape of the resist 401 in FIG. 7B will be described.

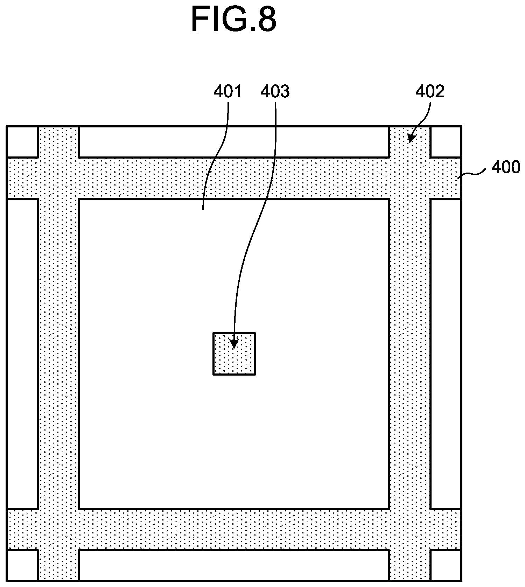

FIG. 8 is a diagram depicting a configuration example of a resist used for on-chip lens formation according to an embodiment of the present disclosure. The drawing is a diagram illustrating an example of a configuration of the resist 401. As illustrated in the drawing, the opening 402 is a groove-shaped opening formed at a boundary of the pixel block 20. Furthermore, the opening 403 is formed at the center of the pixel block 20. The opening 403 in the drawing illustrates an example of being formed in a rectangular shape. Note that the drawing illustrates an example of the resist 401 forming the on-chip lens 170 having a rectangular shape in plan view. By disposing the opening 402, the thickness of the central portion of the resist 401 after heating can be reduced. By etching the material film 400 using the resist 401 having such a shape, the on-chip lens 170 having the non-condensing region 171 formed in the concave portion can be formed.

Note that, to form the second on-chip lens 179, the resist 401 in which the opening 403 is not arranged is used.

### [Modification 1]

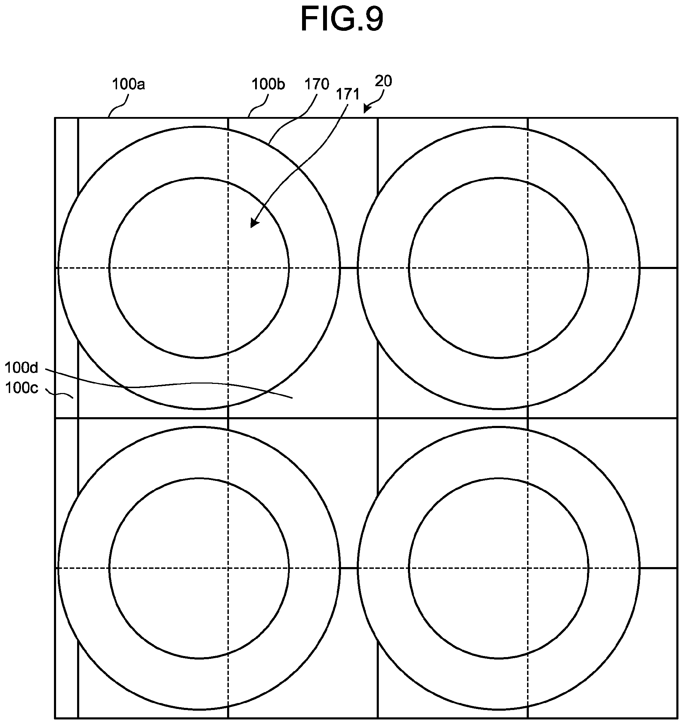

FIG. 9 is a diagram depicting a configuration example of a pixel according to a first modification of the first embodiment of the present disclosure. Similarly to FIG. 2, the drawing is a plan view depicting a configuration example of the pixel block 20. The on-chip lens 170 in the drawing is different from the on-chip lens 170 in FIG. 2 in that the on-chip lens is arranged to be shifted from the center of the pixel block 20. The drawing illustrates an example in which the on-chip lens 170 is arranged to be shifted to the left side of the drawing. As described above, incident light is obliquely incident on the pixel block 20 arranged in a region other than the center of the pixel region 3. Therefore, the on-chip lens 170 is arranged to be shifted in the incident direction of the incident light. The pixel block 20 in the drawing depicts an example of the pixel block 20 arranged on the right side of the pixel region 3. Such process of arranging the on-chip lens 170 to be shifted in the incident direction of the incident light is referred to as pupil correction. In the pixel block 20 in the drawing, the on-chip lens 170 can be arranged to be shifted according to the incident angle of the incident light.

### [Modification 2]

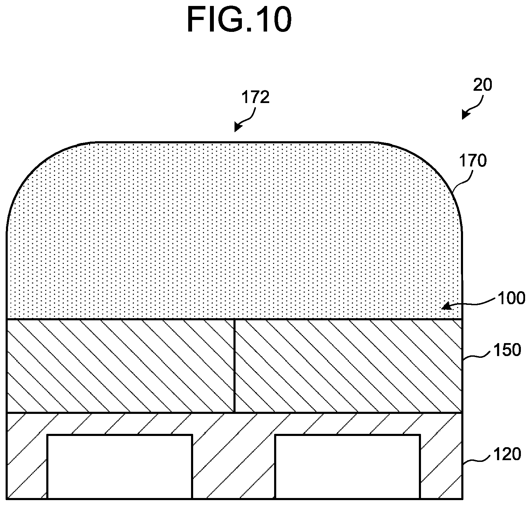

FIG. 10 is a diagram depicting a configuration example of a pixel according to a second modification of the first embodiment of the present disclosure. Similarly to FIG. 4A, the drawing is a cross-sectional view illustrating a configuration example of the pixel block 20. The on-chip lens 170 in the drawing is different from the on-chip lens 170 in FIG. 4A in having a non-condensing region 172 formed in a flat region. With the flat surface, the incident light travels straight, and the light condensing range 310 of the on-chip lens 170 can be widened.

The non-condensing region 171 in FIG. 4A is formed by a curved surface of a concave portion, and the non-condensing region 172 in the drawing is formed by a flat surface (surface having a curvature of 0). In addition, a convex portion having a small curvature is also included in the non-condensing region of the present disclosure. For example, the focal position becomes the wiring region 140 in the lower layer of the semiconductor substrate 120, therefore the non-condensing region also includes a convex portion having a curvature that does not substantially contribute to condensing of the incident light.

As described above, the imaging apparatus 1 according to the first embodiment of the present disclosure can widen the light condensing range 310 by arranging the on-chip lens 170 including the non-condensing region 171 and the like in the pixel block 20. As a result, even in a case where the position of the on-chip lens 170 varies, the influence of the light condensing shift can be reduced.

### (2. Second Embodiment)

The imaging apparatus 1 of the first embodiment described above uses the on-chip lens 170 having a uniform thickness in the peripheral portion. On the other hand, an imaging apparatus 1 according to a second embodiment of the present disclosure is different the one from the above-described first embodiment in using an on-chip lens 170 with a thickness of a peripheral portion adjusted.

### [Configuration of Pixel]

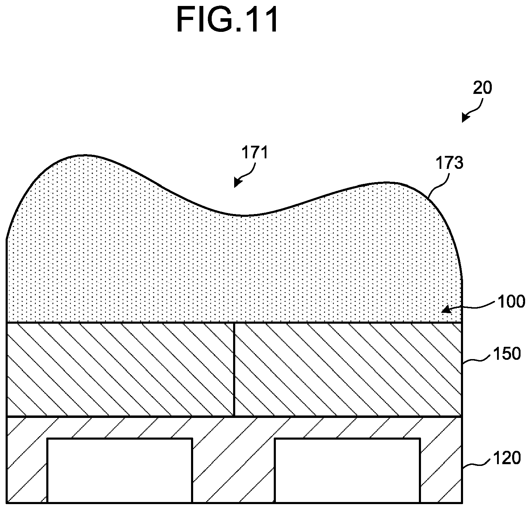

FIG. 11 is a diagram depicting a configuration example of the pixel according to the second embodiment of the present disclosure. Similarly to FIG. 4A, the drawing is a cross-sectional view illustrating a configuration example of the pixel block 20. The pixel block 20 in the drawing is different from the pixel block 20 in FIG. 4A in having a on-chip lens 173 with a thickness of the peripheral portion adjusted.

The on-chip lens 173 in the drawing adjusts the thickness of a part of the peripheral portion adjacent to the non-condensing region 171. Specifically, the thickness of the peripheral portion on the right side is reduced with respect to the left side of the drawing. As a result, the light condensing range of the incident light in the right peripheral portion can be widened. As a result, in a case where the incident light obliquely enters from the left side in the drawing, the light condensing range can be widened, and the influence of the light condensing shift can be reduced. The on-chip lens 173 can be formed by shifting the position of the opening 403 of the resist 401 described in FIG. 8. As described above, by reducing the obliquely incident angle, it is possible to reduce the positional shift error with respect to the height variation of the on-chip lens 170.

The configuration of the imaging apparatus 1 other than the above is similar to the configuration of the imaging apparatus 1 in the first embodiment of the present disclosure, and thus the description thereof will be omitted.

As described above, the imaging apparatus 1 according to the second embodiment of the present disclosure includes the on-chip lens 170 having the peripheral portion with thickness adjusted according to the incident direction of the incident light. As a result, the influence of the light condensing shift can be further reduced.

### (3. Third Embodiment)

In the imaging apparatus 1 of the first embodiment described above, the color filter 150 is arranged in the pixel block 20. On the other hand, a pixel block 20 according to a third embodiment of the present disclosure is different from the above-described first embodiment in selecting the type of color filter 150 to be arranged.

### [Configuration of Pixel]

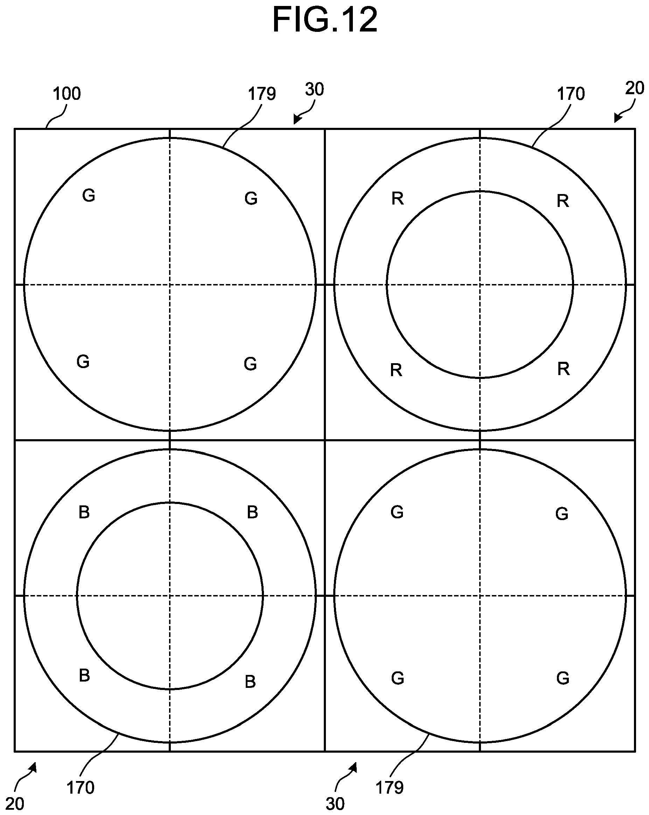

FIG. 12 is a diagram depicting a configuration example of the pixel according to the third embodiment of the present disclosure. Similarly to FIG. 2, the drawing is a plan view depicting a configuration example of the pixel block 20. The pixel block 20 in the drawing is different from the pixel block 20 in FIG. 2 in that color filters 150 corresponding to red light and blue light are arranged. Further, the color filter 150 corresponding to the green light is arranged in the second pixel block 30. In the second pixel block 30 in the drawing, a phase difference signal is generated. Therefore, the second on-chip lens 179 is arranged, and light is condensed at the central portion of the second pixel block 30. Accordingly, the isolation ratio can be improved.

On the other hand, in the pixel block in which the color filters 150 corresponding to the red light and the blue light are arranged, the on-chip lens 170 is arranged to widen the light condensing range. As described with reference to FIG. 3, the isolation section 135 of the pixel 100 is arranged in the central portion of the pixel block 20. The incident light is scattered by the isolation section 135, which causes color mixture. Therefore, in the pixel block 20 in the drawing in which the phase difference signal is not generated, the light condensing range is widened by the on-chip lens 170 to reduce the scattered incident light. As a result, the color mixture of the pixel blocks 20 in which the color filters 150 corresponding to red light and blue light are arranged can be reduced.

### [Another Configuration of Pixel]

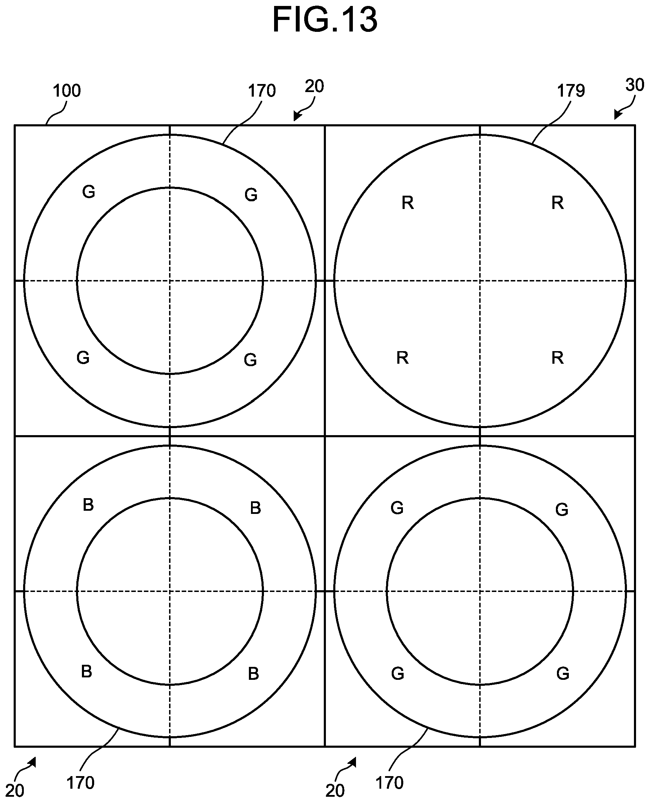

FIG. 13 is a diagram depicting another configuration example of the pixel according to the third embodiment of the present disclosure. Similarly to FIG. 12, the drawing is a plan view depicting a configuration example of the pixel block 20. The pixel block 20 in the drawing is different from the pixel block 20 in FIG. 12 in that color filters 150 corresponding to green light and blue light are arranged. The green light and the blue light having a relatively short wavelength are condensed in the vicinity of the back surface of the semiconductor substrate 120. Therefore, the on-chip lens 170 is arranged in these pixel blocks to widen the light condensing range.

On the other hand, red light having a relatively long wavelength is condensed in a deep portion of the semiconductor substrate 120. For this reason, the pixel block including the color filter 150 corresponding to the red light is hardly affected by the light condensing shift. Therefore, the second on-chip lens 179 is arranged in the pixel block in which the color filter 150 corresponding to red light is arranged. As a result, the light condensing range of the second pixel block 30 is narrowed to improve the isolation ratio.

In addition, by matching the light condensing state for each wavelength of the incident light, the phase difference at each wavelength becomes substantially equal, so that the accuracy of autofocus can be improved.

The configuration of the imaging apparatus 1 other than the above is similar to the configuration of the imaging apparatus 1 in the first embodiment of the present disclosure, and thus the description thereof will be omitted.

As described above, the imaging apparatus 1 according to the third embodiment of the present disclosure selects the on-chip lens 170 and the second on-chip lens 179 according to the type of the color filter 150 arranged in the pixel block. As a result, it is possible to set the light condensing range according to the light having the wavelength selected by the color filter 150.

### (4. Fourth Embodiment)

In the imaging apparatus 1 of the first embodiment described above, the four pixels 100 are arranged in the pixel block. On the other hand, an imaging apparatus 1 according to a fourth embodiment of the present disclosure is different from the above-described first embodiment in that two pixels 100 are arranged in a pixel block.

### [Configuration of Pixel]

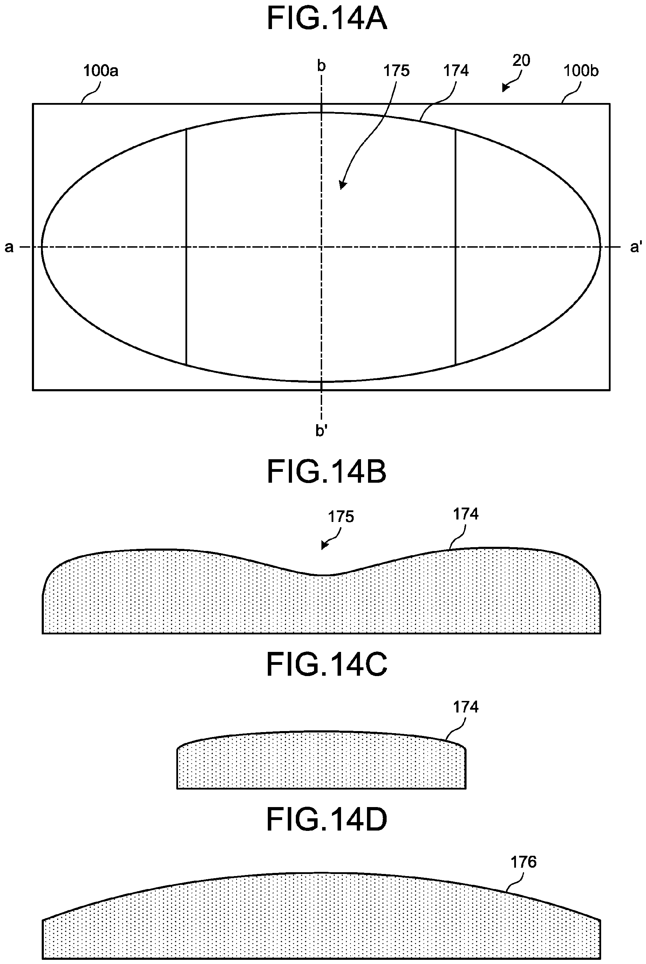

FIG. 14A is a diagram depicting a configuration example of the pixel according to the fourth embodiment of the present disclosure. Similarly to FIG. 2, the drawing is a plan view depicting a configuration example of the pixel block 20. The pixel block 20 in the drawing is different from the pixel block 20 in FIG. 2 in that an on-chip lens (on-chip lens 174) is commonly arranged in the two pixels 100.

The drawing depicts an example in which the on-chip lens 174 is formed in an elliptical shape in plan view. In a central portion of the on-chip lens 174, a non-condensing region 175 configured by a groove-shaped concave portion is arranged. The pixels 100a and 100b in the drawing generate a phase difference signal. These pixels 100a and 100b pupil-divide the subject in adjacent directions. The non-condensing region 175 in the drawing is formed in a direction orthogonal to the pupil division direction of the pixels 100a and 100b.

### [Configuration of On-Chip Lens]

FIGS. 14B to 14C are diagrams depicting a configuration example of an on-chip lens according to the fourth embodiment of the present disclosure. FIG. 14B is a cross-sectional view of the on-chip lens 174 taken along line a-a' of FIG. 14A. Furthermore, FIG. 14C is a cross-sectional view of the on-chip lens 174 taken along line b-b' of FIG. 14A. By arranging the non-condensing region 175 having such a shape, the light condensing range can be widened in the direction of pupil division.

Note that FIG. 14D is a cross-sectional view illustrating a configuration example of a on-chip lens 176 arranged in the second pixel block 30. The drawing is a diagram illustrating the shape of the cross section of the on-chip lens 176 in the longitudinal direction, similarly to FIG. 14B. The shape of the cross section of the on-chip lens 176 in the latitude direction can be similar to that in FIG. 14C. The on-chip lens 176 in the drawing has a relatively narrow light condensing range.

### [Arrangement of Pixel Blocks]

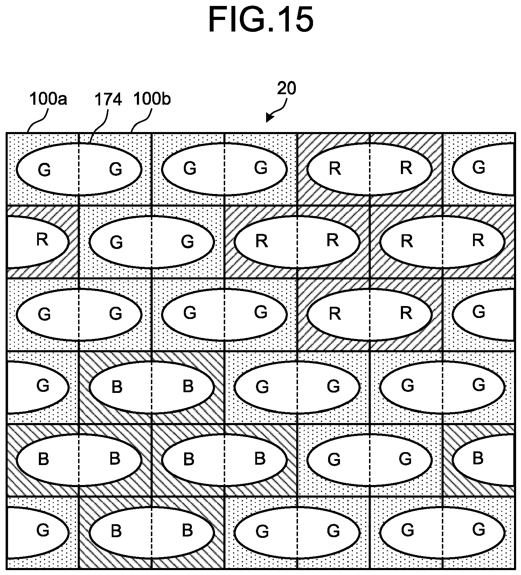

FIG. 15 is a diagram depicting an arrangement example of a pixel block according to the fourth embodiment of the present disclosure. The drawing is a plan view illustrating an arrangement example of the pixel block 20. The pixel block 20 can be arranged to be shifted by one pixel (pixel 100) for each row of the pixel region 3. Furthermore, four or five adjacent pixel blocks 20 can be set as one group, and the pixel blocks 20 can be arranged in the Bayer array in four groups.

### [Another Arrangement of Pixel Blocks]

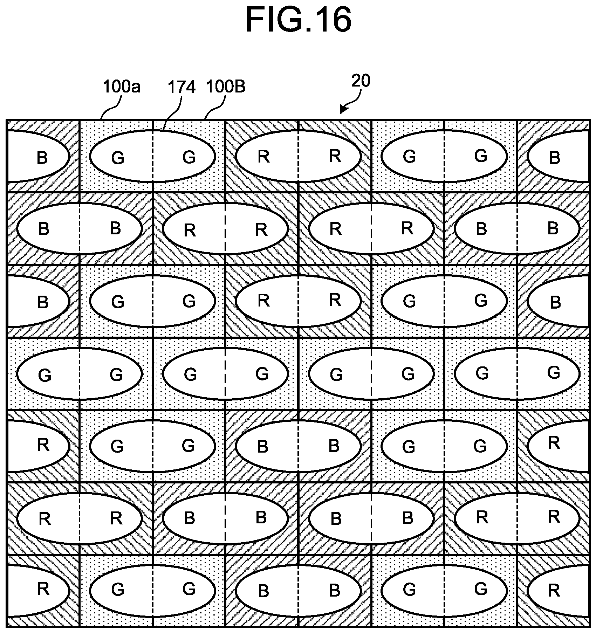

FIG. 16 is a diagram depicting another arrangement example of the pixel block according to the fourth embodiment of the present disclosure. The drawing is a diagram illustrating an example in which four adjacent pixel blocks 20 are set as one group and four groups are arranged in the Bayer array. The four groups are different from the four groups constituting the Bayer array in FIG. 15 in that the number of pixel blocks 20 corresponding to green and the number of pixel blocks 20 corresponding to red and blue are the same (four each).

### [Another Arrangement of Pixel Blocks]

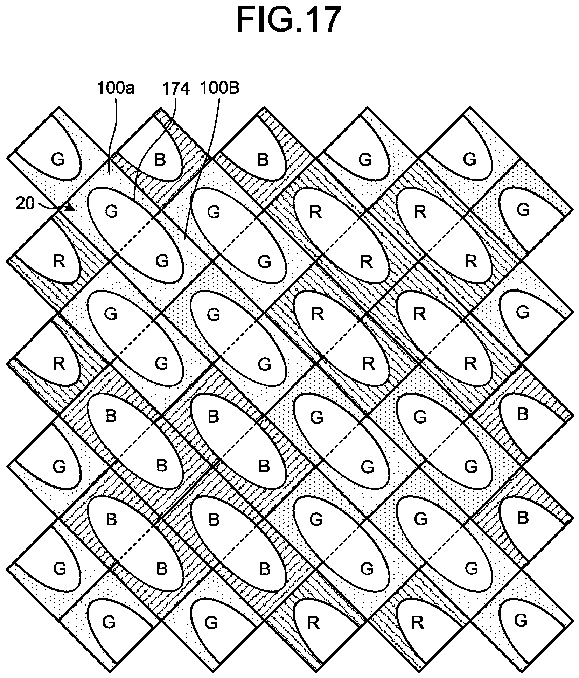

FIG. 17 is a diagram depicting another arrangement example of the pixel block according to the fourth embodiment of the present disclosure. The drawing is a diagram illustrating an example in which the pixel blocks 20 are rotated by 45 degrees to be arranged, four adjacent pixel blocks 20 are set as one group, and four groups are arranged in the Bayer array. The four groups are different from the four groups constituting the Bayer array in FIG. 15 in that the number of pixel blocks 20 corresponding to green and the number of pixel blocks 20 corresponding to red and blue are the same.

The configuration of the imaging apparatus 1 other than the above is similar to the configuration of the imaging apparatus 1 in the first embodiment of the present disclosure, and thus the description thereof will be omitted.

As described above, in the imaging apparatus 1 according to the fourth embodiment of the present disclosure, the on-chip lens 174 is commonly arranged in the two pixels 100, and the light condensing range is widened. As a result, it is possible to reduce the influence of the light condensing shift in the pixel block 20 including the two pixels 100.

### (5. Fifth Embodiment)

The imaging apparatus 1 of the above-described fourth embodiment uses the pixels 100 having a square shape. On the other hand, an imaging apparatus 1 according to the fifth embodiment of the present disclosure is different from the above-described fourth embodiment in using a pixel 100 having a rectangular shape.

### [Configuration of Pixel Block]

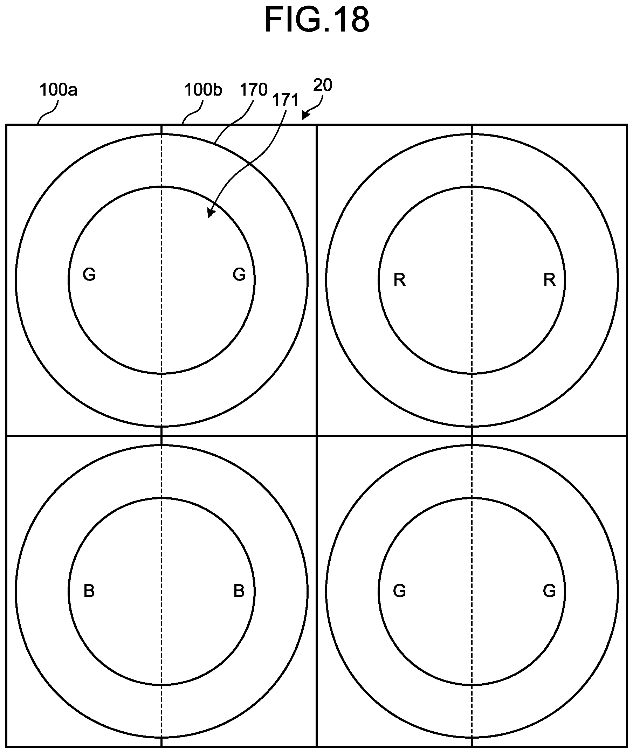

FIG. 18 is a diagram depicting a configuration example of the pixel block according to the fifth embodiment of the present disclosure. The drawing is a plan view depicting a configuration example of the pixel block 20. The pixel block 20 in the drawing includes pixels 100a and 100b having a rectangular shape in plan view. Therefore, the pixel block 20 in the drawing has a square shape in plan view. Furthermore, the on-chip lens 170 can be formed in a circular shape in plan view. Furthermore, the on-chip lens 170 in the drawing illustrates an example in which the non-condensing region 171 is arranged at the central portion.

### [Another Configuration of Pixel Block]

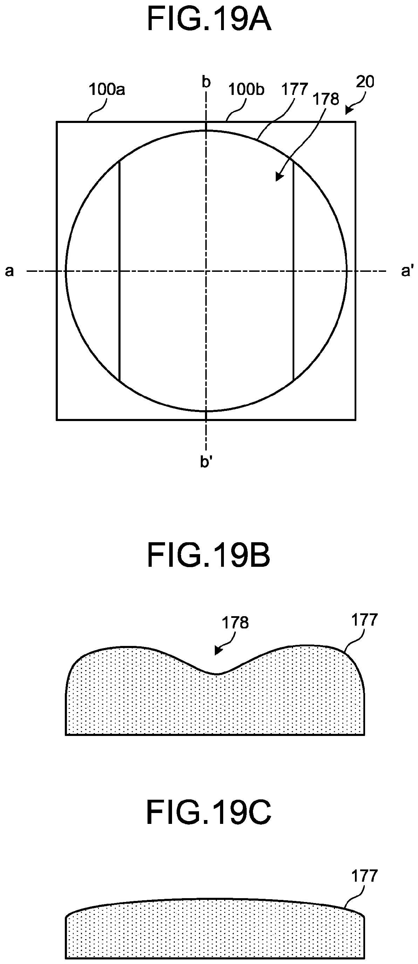

FIG. 19A is a diagram depicting another configuration example of the pixel block according to the fifth embodiment of the present disclosure. The drawing is a plan view depicting a configuration example of the pixel block 20. In the pixel block 20 in the drawing, similarly to the on-chip lens 174 described in FIG. 14A, a on-chip lens 177 including a non-condensing region 178 configured by the groove-shaped concave portion is arranged.

FIGS. 19B and 18C are diagrams depicting a configuration example of an on-chip lens according to the fifth embodiment of the present disclosure. FIG. 19B is a cross-sectional view of the on-chip lens 177 taken along line a-a' of FIG. 19A. Furthermore, FIG. 19C is a cross-sectional view of the on-chip lens 177 taken along line b-b' of FIG. 19A. By arranging the non-condensing region 178 having such a shape, the light condensing range can be widened in the direction of pupil division.

### [Arrangement of Pixel Blocks]

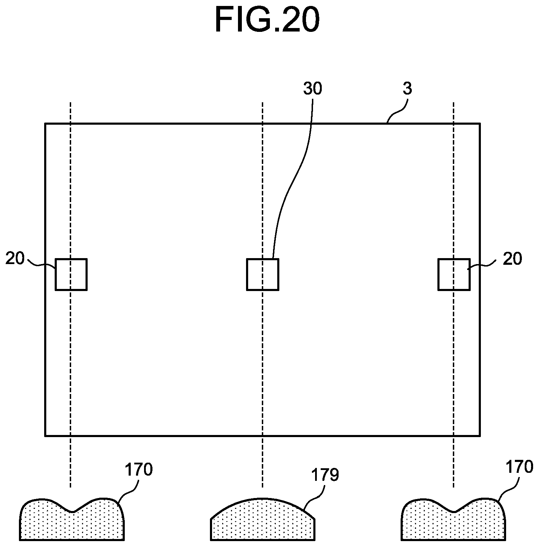

FIG. 20 is a diagram depicting an arrangement example of a pixel block according to the fifth embodiment of the present disclosure. The drawing is a plan view illustrating an arrangement example of the pixel block 20. The pixel region 3 in the drawing represents an example in which the pixel block 20 that perform pupil division in the lateral direction in the drawing and the second pixel block 30 are arranged. Furthermore, as the pixel block 20 in the drawing, the pixel block 20 illustrated in FIG. 18 can be used. Furthermore, to the second pixel block 30 in the same drawing, the second pixel block 30 in which the second on-chip lens 179 is commonly arranged in the two pixels 100a and 100b illustrated in FIG. 18 can be applied.

The second pixel block 30 is arranged along a line passing through the center of the pixel region 3. The pixel block 20 can be arranged in the other pixel region 3. The pixel block 20 adjusts the light condensing range 310 of the on-chip lens 170 according to the distance from the line passing through the center of the pixel region 3. Specifically, the on-chip lens 170 of the pixel block 20 in the region close to a line passing through the center of the pixel region 3 narrows the light condensing range 310. Then, the light condensing range 310 of the on-chip lens 170 is widened as the distance from the line passing through the center of the pixel region 3 increases. Note that the pixel block 20 can perform pupil correction for the on-chip lens 170.

### [Another Arrangement of Pixel Blocks]

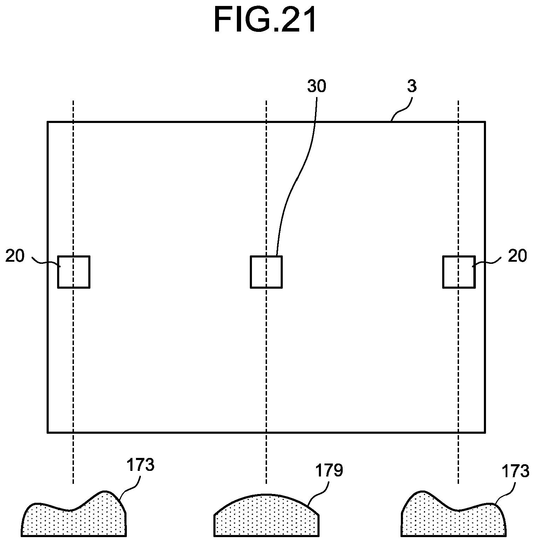

FIG. 21 is a diagram depicting another arrangement example of the pixel block according to the fifth embodiment of the present disclosure. The drawing illustrates an example of a case where the on-chip lens 173 described in FIG. 11 is arranged in the pixel block 20. Also in the drawing, the pixel block 20 can perform pupil correction for the on-chip lens 173.

The configuration of the imaging apparatus 1 other than the above is similar to the configuration of the imaging apparatus 1 in the first embodiment of the present disclosure, and thus the description thereof will be omitted.

As described above, the imaging apparatus 1 according to the fifth embodiment of the present disclosure can reduce the influence of the light condensing shift in the pixel block 20 including the pixels 100a and 100b having the rectangular shape. Furthermore, in the peripheral edge portion of the pixel region 3, incident light is obliquely incident on the pixel 100. In this oblique incidence, light shielding of incident light called vignetting occurs by the light shielding film 159, and the isolation ratio in the phase difference pixel decreases. However, by arranging the non-condensing region 171 in the on-chip lens 170, the angle of the incident light can be suppressed (shallowed), and vignetting can be suppressed. Accordingly, the isolation ratio can be improved.

### (6. Sixth Embodiment)

The imaging apparatus 1 of the first embodiment described above includes the pixel region 3 in which the plurality of pixel blocks 20 is arranged in the Bayer array. On the other hand, an imaging apparatus 1 according to a sixth embodiment of the present disclosure is different from the above-described first embodiment in that the imaging apparatus 1 includes a pixel unit including a plurality of pixel blocks 20.

### [Configuration of Pixel Unit]

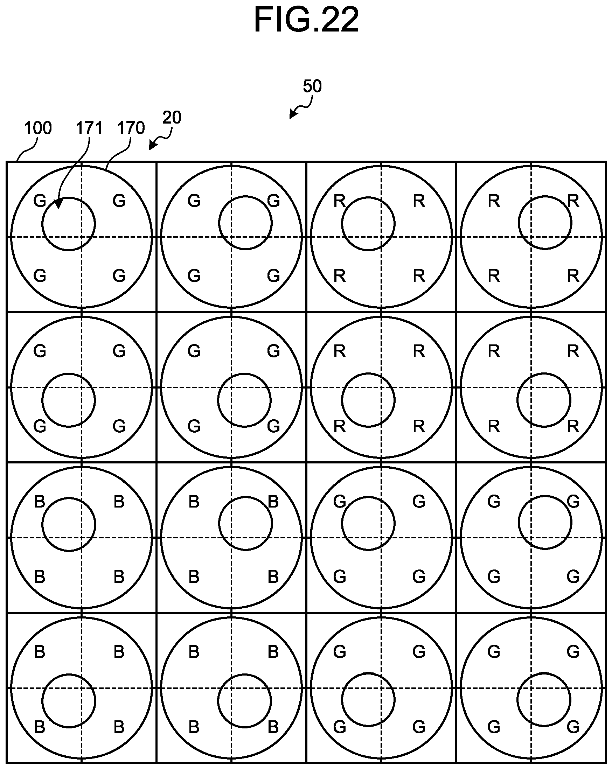

FIG. 22 is a diagram depicting a configuration example of a pixel unit according to the sixth embodiment of the present disclosure. The drawing is a plan view depicting a configuration example of a pixel unit 50. The pixel unit 50 in the drawing is configured by arranging a plurality of pixel blocks 20 having color filters 150 corresponding to the same color in 2 rows and 2 columns. Furthermore, the drawing illustrates an example in which four pixel units 50 each including a pixel block 20 having color filters 150 corresponding to red light, green light, and blue light are arranged in a Bayer array. By providing the pixel region 3 in which the pixel unit 50 including the plurality of pixel blocks 20 having the color filters 150 of the same color is arranged, the resolution of the imaging apparatus 1 can be easily changed. Specifically, the resolution of the imaging apparatus 1 can be changed to three types of resolutions: a resolution based on the pixel 100, a resolution based on the pixel block 20, and a resolution based on the pixel unit 50.

The pixel unit 50 in the drawing illustrates an example in which the non-condensing region 171 of the on-chip lens 170 of each pixel block 20 is arranged at a position shifted in the direction towards the outside the pixel unit 50. By arranging the non-condensing region 171 of the on-chip lens 170 to be shifted in the direction towards the outer side of the pixel unit 50, the incident light can be condensed on the pixel 100 on the inner side of the pixel unit 50. Therefore, incident light directed to another adjacent pixel unit 50 can be reduced, and color mixture can be reduced.

### [Another Configuration of Pixel Unit]

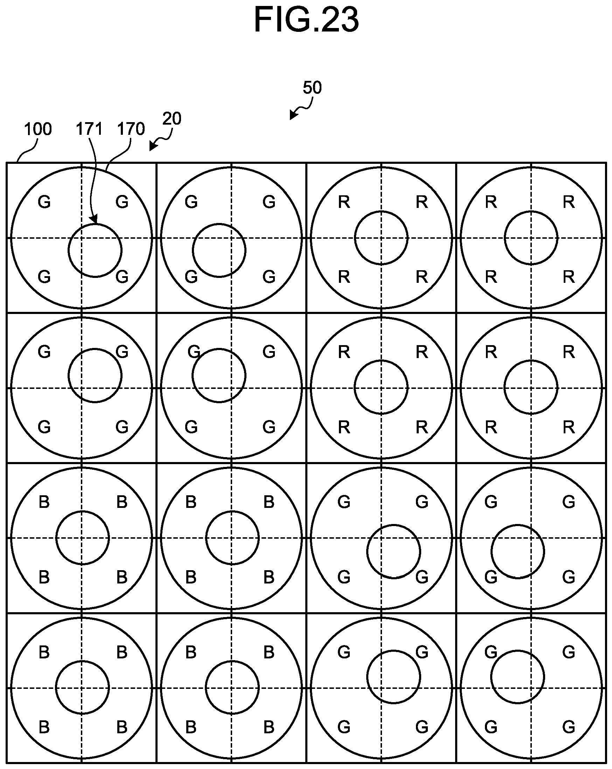

FIG. 23 is a diagram depicting another configuration example of the pixel unit according to the sixth embodiment of the present disclosure. Similarly to FIG. 22, the drawing is a plan view depicting a configuration example of the pixel unit 50. The pixel unit 50 in the drawing is different from the pixel unit 50 in FIG. 22 in that the non-condensing region 171 of the on-chip lens 170 of the pixel unit 50 corresponding to green light is arranged at a position shifted in the direction inside the pixel unit 50. Note that the non-condensing regions 171 of the on-chip lenses 170 of the pixel blocks 20 corresponding to red and blue in the drawing are arranged at positions that are not shifted.

By arranging the non-condensing region 171 of the on-chip lens 170 of the pixel unit 50 corresponding to the green light at a position shifted in the direction inside the pixel unit 50, the sensitivity of the pixel 100 in the peripheral edge portion of the pixel unit 50 can be improved. As a result, it is possible to reduce the influence of color mixture on the pixel units 50 corresponding to the green light from the pixel units 50 corresponding to other colors. Note that the configuration of the on-chip lens 170 in which the non-condensing region 171 is arranged at a position shifted in the direction inside the pixel unit 50 can be applied to at least one of the pixel unit 50 corresponding to red light, the pixel unit 50 corresponding to green light, and the pixel unit 50 corresponding to blue light.

Furthermore, the configurations of the pixel units 50 in FIGS. 22 and 23 can be combined. For example, the arrangement of the non-condensing region 171 of the on-chip lens 170 in the pixel unit 50 corresponding to the red light in FIG. 22 can be applied to the pixel unit 50 corresponding to the red light in FIG. 23. In this case, the non-condensing region 171 of the on-chip lens 170 of the pixel unit 50 corresponding to the red light can be shifted in the direction towards the outer side so as to condense the incident light on the pixel 100 on the inner side of the pixel unit 50. This makes it possible to reduce color mixture to the pixels 100 around the pixel unit 50 corresponding to red light. It is possible to further reduce color mixture of incident light having a long wavelength which tends to be a problem.

### [Another Configuration of Pixel Unit]

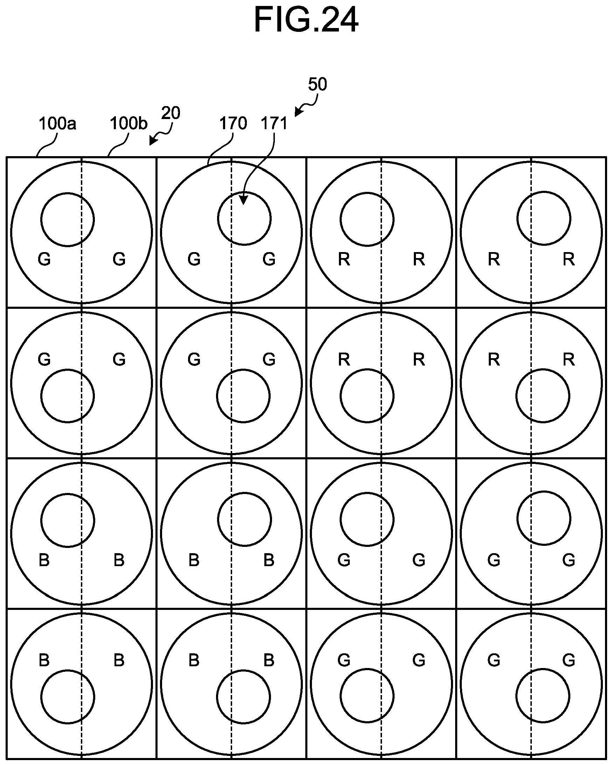

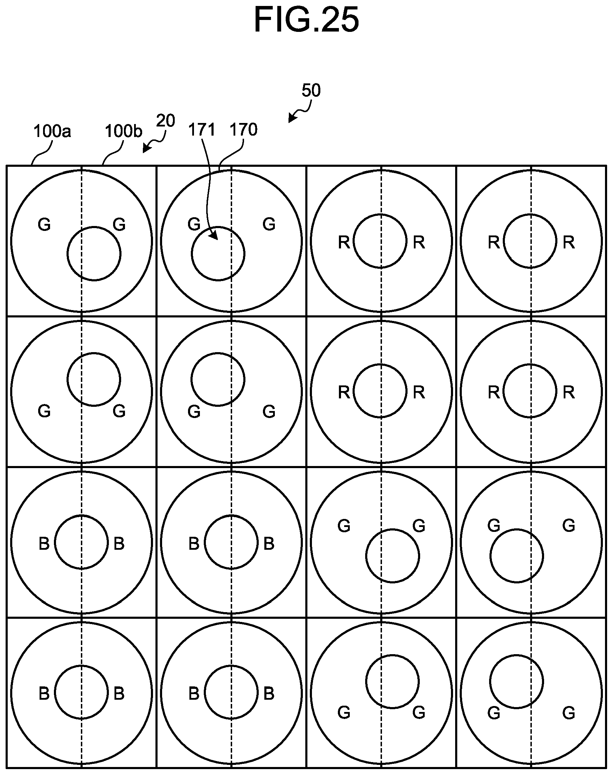

FIGS. 24 and 25 are diagrams depicting another configuration example of the pixel unit according to the sixth embodiment of the present disclosure. Similarly to FIG. 22, the drawing is a plan view depicting a configuration example of the pixel unit 50. The pixel unit 50 in the drawing is different from the pixel unit 50 in FIG. 22 in that the pixel unit 50 is constituted by a pixel block 20 including the pixels 100a and 100b illustrated in FIG. 18. Similarly to FIG. 22, FIG. 24 illustrates an example in which the non-condensing region 171 of the on-chip lens 170 of each pixel block 20 of the pixel unit 50 is arranged at a position shifted in the direction towards the outside the pixel unit 50. Further, similarly to FIG. 23, FIG. 25 illustrates an example in which the non-condensing region 171 of the on-chip lens 170 of the pixel unit 50 corresponding to green light is arranged at a position shifted in the direction inside the pixel unit 50.

The configuration of the imaging apparatus 1 other than the above is similar to the configuration of the imaging apparatus 1 in the first embodiment of the present disclosure, and thus the description thereof will be omitted.

As described above, the imaging apparatus 1 according to the sixth embodiment of the present disclosure adjusts the position of the non-condensing region 171 of the on-chip lens 170 for each pixel unit 50. Thus, color mixture can be reduced.

### (7. Seventh Embodiment)

In the imaging apparatus 1 of the fourth embodiment described above, the plurality of pixel blocks 20 having the two pixels 100 is arranged to be shifted by one pixel each. On the other hand, an imaging apparatus 1 according to a seventh embodiment of the present disclosure is different from the above-described fourth embodiment in adjusting the size of a non-condensing region 171 of an on-chip lens 170 of a plurality of pixel blocks 20 having two pixels 100.

### [Configuration of Pixel Unit]

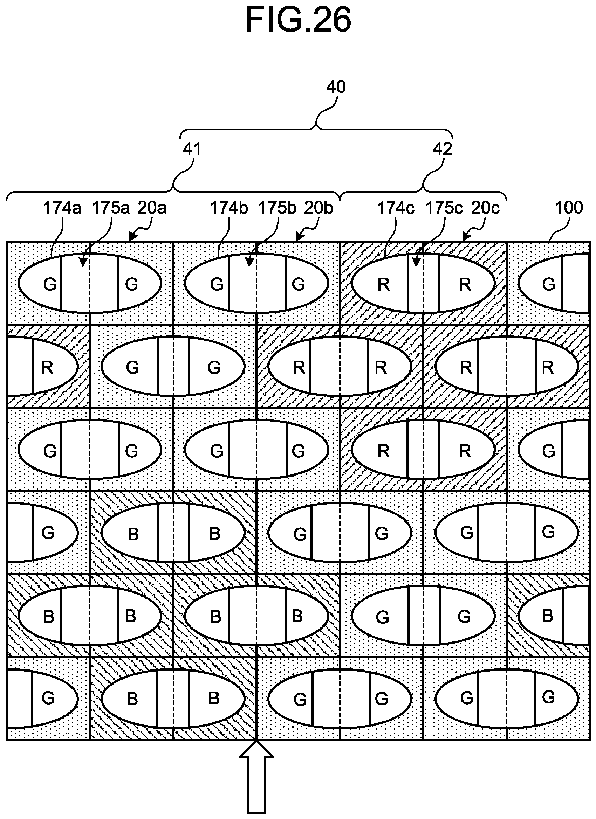

FIG. 26 is a diagram depicting a configuration example of a pixel block according to the seventh embodiment of the present disclosure. The drawing is a plan view depicting a configuration example of the pixel block 20. Similarly to FIG. 15, in the pixel blocks 20 in the drawing, the on-chip lenses 174 arranged in common in the two pixels 100 and the two pixels 100, which are adjacent in the row direction and include the color filters 150 that transmit the incident light of the same wavelength, are arranged in the matrix direction of the pixel blocks 20. The pixel block 20 is arranged to be shifted by one pixel 100 for each row.

Here, two pixel blocks 20 (a pixel block 20a and a pixel block 20b in the drawing) adjacent to each other in the row direction, each of which includes a color filter 150 that transmits incident light having the same wavelength, and a pixel block 20 (a pixel block 20c in the drawing) that is arranged adjacent to these pixel blocks 20 in the row direction and includes a color filter 150 that transmits incident light having different wavelengths are referred to as a pixel group 40. The pixel region 3 in the drawing can be regarded as a plurality of pixel groups 40 arrayed. Furthermore, in the pixel group 40, two pixel blocks 20a and 20b including the color filter 150 corresponding to the same color are referred to as a multi-pixel portion 41, and one pixel block 20c including the color filter 150 different from that included by the pixel block 20 of the multi-pixel portion 41 is referred to as a single pixel portion 42.

The pixel group 40 in the drawing represents an example in which the non-condensing regions 171 having different sizes are arranged in the multi-pixel portion 41 and the single pixel portion 42. Specifically, the single pixel portion 42 in the drawing includes the non-condensing region 171 having a size smaller than the non-condensing region 171 of the multi-pixel portion 41. As a result, the light condensing range of the pixel block 20 of the single pixel portion 42 can be narrowed with respect to the pixel block 20 of the multi-pixel portion 41.

In the pixel blocks 20 in the drawing, color mixture in the pixel blocks 20 becomes a problem. As illustrated in the drawing, in the configuration in which the pixel blocks 20 are arrayed to be shifted for each row, in a case where there is an image boundary in the column direction (for example, a direction of a white arrow in the drawing), color mixture changes for each row in the pixels 100 adjacent in the column direction. Specifically, even if the actual image is the same in the column direction in the portion indicated by the white arrow in the drawing, whether the actual image is mixed with the pixel 100 on the right side or the pixel 100 on the left side in the row direction alternately changes. For this reason, the output image of the white arrow portion in the drawing is not uniform, and the image quality of the boundary portion of the actual image may be deteriorated.

This change in the image changes depending on the intensity of the internal color mixture of the pixel block 20. The internal color mixture of the pixel block 20 increases as the light condensing range of the on-chip lens 170 is narrower. In order to reduce this influence, the light condensing range of the pixel block 20 arranged at the boundary among the pixel blocks 20 of the same color is widened, and the light condensing range of the pixel block 20 arranged at the center among the pixel blocks 20 of the same color is narrowed. Specifically, the size of the non-condensing region 171 of the on-chip lens 170 of the pixel block 20 of the single pixel portion 42 is reduced to narrow the light condensing range. As a result, it is possible to increase the internal color mixture of the pixel block 20 of the single pixel portion 42 and reduce the change in color mixture in the row direction. Note that the non-condensing region 171 of the on-chip lens 170 of the pixel block 20 of the multi-pixel portion 41 can be deleted.

### [Another Configuration of Pixel Unit]

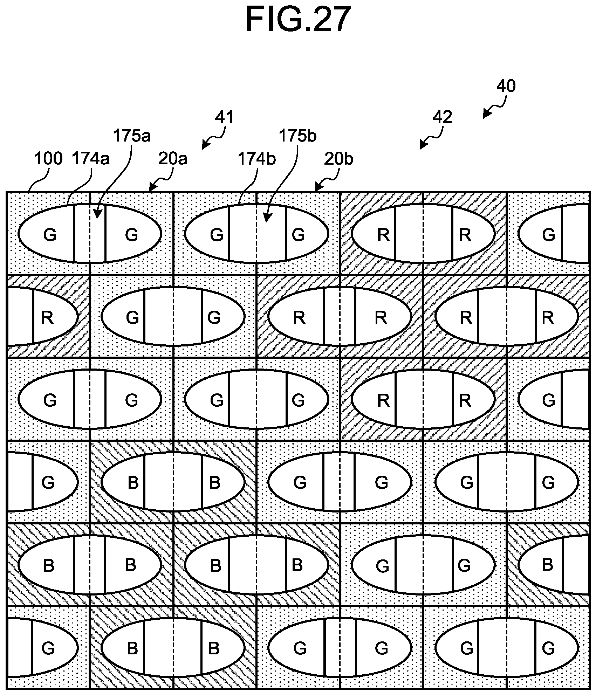

FIG. 27 is a diagram depicting another configuration example of the pixel block according to the seventh embodiment of the present disclosure. Similarly to FIG. 26, the drawing is a plan view depicting a configuration example of the pixel block 20. The pixel blocks 20a and 20b constituting the multi-pixel portion 41 in the drawing are different from the pixel blocks 20 in FIG. 26 in that the non-condensing regions 171 having different sizes are arranged.

The incident light is obliquely incident on the pixel group 40 in the peripheral edge portion of the pixel region 3. For example, in a case where the incident light is obliquely incident in the row direction in the drawing, the influence of color mixture of the pixel block 20b increases as compared with the pixel block 20a. This is because the pixel block 20 corresponding to different colors is arranged on the right side of the pixel block 20b. Therefore, the size of the non-condensing region 171 of the pixel block 20b is made larger than the non-condensing region 171 of the pixel block 20a, and the light condensing range is widened. Thus, the influence of color mixture can be reduced.

The configuration of the imaging apparatus 1 other than the above is similar to the configuration of the imaging apparatus 1 in the fourth embodiment of the present disclosure, and thus the description thereof will be omitted.

As described above, the imaging apparatus 1 according to the seventh embodiment of the present disclosure adjusts the size of the non-condensing region 171 of each pixel block 20 of the pixel group 40. Thus, the influence of color mixture can be reduced.

### (8. Eighth Embodiment)

In the imaging apparatus 1 of the first embodiment described above, the pixel block 20 in which the on-chip lens 170 common to the plurality of pixels 100 is arranged is arranged in the pixel region 3. On the other hand, an imaging apparatus 1 according to an eighth embodiment of the present disclosure is different from the above-described first embodiment in that the imaging apparatus 1 includes a pixel region 3 including a pixel 100 in which an on-chip lens is arranged for each pixel 100 of the imaging apparatus 1.

### [Configuration of Pixel Unit]

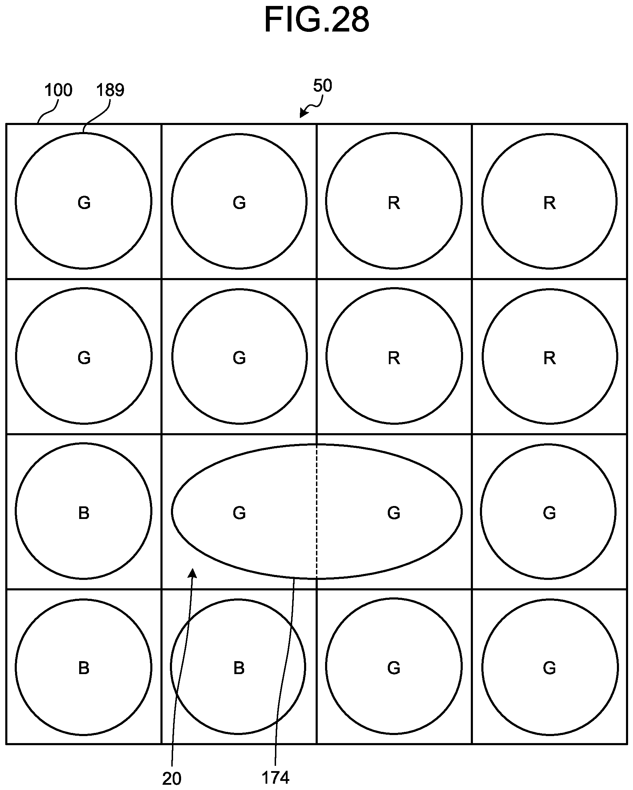

FIG. 28 is a diagram depicting a configuration example of a pixel block according to the eighth embodiment of the present disclosure. The drawing illustrates an example in which the pixel unit 50 including the plurality of pixels 100 in which an on-chip lens 189 having a circular shape is arranged is arranged in the Bayer array. The pixel block 20 in which the on-chip lens 174 is commonly arranged in the two pixels 100 is arranged in a part of the four pixel units 50 of the Bayer array. The pixel block 20 generates a phase difference signal. Furthermore, by arranging the non-condensing region 175 also in the on-chip lens 170 of the pixel block 20, color mixture can be reduced. This effect is remarkably exhibited in the peripheral edge portion of the pixel region 3.

The configuration of the imaging apparatus 1 other than the above is similar to the configuration of the imaging apparatus 1 in the first embodiment of the present disclosure, and thus the description thereof will be omitted.

### (9. Ninth Embodiment)

In the imaging apparatus 1 of the first embodiment described above, the pixels 100 are arranged in the pixel region 3. On the other hand, an imaging apparatus 1 according to a ninth embodiment of the present disclosure is different from the above-described first embodiment in that a spectroscopic element is arranged in a pixel 100.

### [Configuration of Pixel]

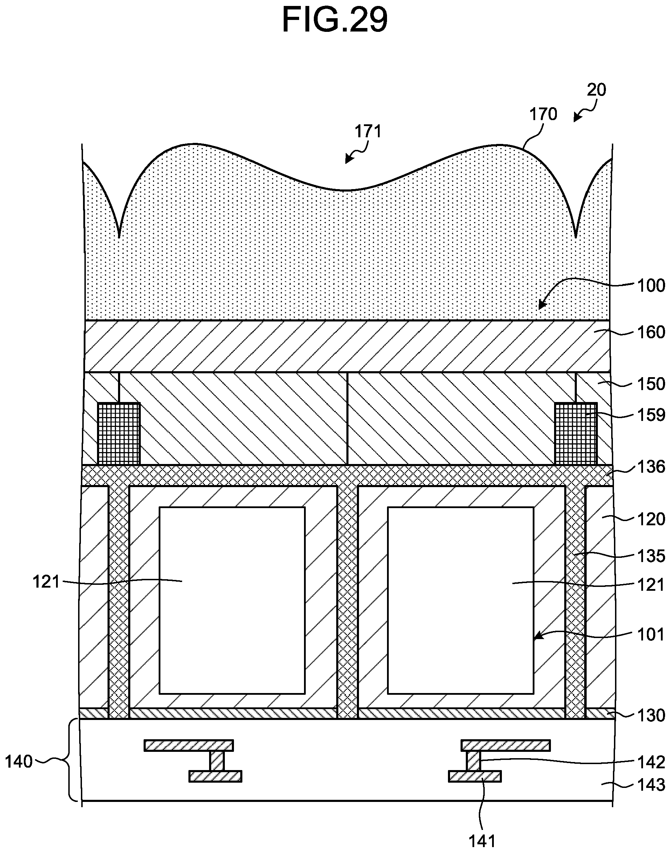

FIG. 29 is a diagram depicting a configuration example of the pixel according to the ninth embodiment of the present disclosure. Similarly to FIG. 3, the drawing is a cross-sectional view illustrating a configuration example of the pixel 100. The pixel 100 in the drawing is different from the pixel 100 in FIG. 3 in that a spectroscopic element 160 is additionally arranged between the color filter 150 and the on-chip lens 170.

The spectroscopic element 160 disperses incident light in a predetermined wavelength range. Specifically, the spectroscopic element 160 disperses the incident light in different directions according to the wavelength.

### [Configuration of Pixel Block]

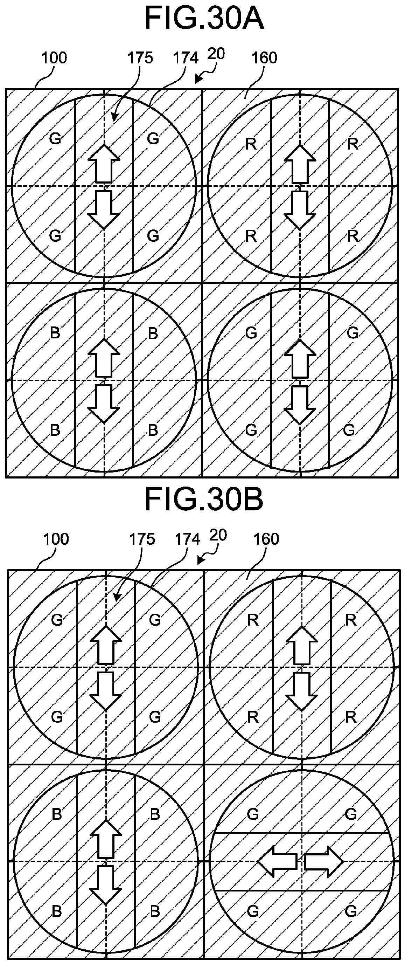

FIGS. 30A and 30B are diagrams depicting a configuration example of the pixel according to the ninth embodiment of the present disclosure. Similarly to FIG. 2, the drawing is a plan view depicting a configuration example of the pixel 100. In addition, the drawing is a diagram depicting a configuration example of a pixel block 20 according to the ninth embodiment of the present disclosure. In the drawing, white arrows indicate the dispersing direction of the spectroscopic element 160. The spectroscopic element 160 disperses the long-wavelength incident light and the short-wavelength incident light in different directions. If it is explained with an example of the pixel unit 50 corresponding to the green light in FIG. 30A, the spectroscopic element 160 spectrally disperses the long-wavelength incident light and the short-wavelength incident light with respect to the substantially central wavelength of the wavelength band corresponding to the green light in different directions (vertical directions indicated by white arrows in the drawing). Therefore, the upper pixel 100 and the lower pixel 100 of the pixel unit 50 receive green light in a narrower band as compared with the normal pixel 100 that detects incident light in a wavelength band corresponding to green light, and wavelength resolution of the incident light can be improved. Thus, color reproducibility can be improved.

The groove-shaped non-condensing region 175 of the on-chip lens 174 in the drawing can be formed substantially parallel to the direction of the dispersing of the spectroscopic element 160. As a result, the light condensing range in the dispersing direction of the spectroscopic element 160 can be widened, and the condensing can be weakened. That is, in the direction in which the image plane phase difference is detected (perpendicular to the arrow in the drawing), the incident light is condensed in a narrow region, and the isolation ratio of the phase difference pixels is secured. This assumes the imaging apparatus 1 to which autofocus that requires a relatively high isolation ratio is applied. On the other hand, in the dispersing direction that does not contribute to the isolation ratio, the light condensing range of the incident light is widened to reduce scattering by the isolation section 135, and color mixture can be reduced. In addition, for example, in a case where a member having angle dependency such as a meta-surface or a prism is used as the spectroscopic element 160, the incident angle becomes shallow by weakening the light condensing, and the spectroscopic characteristics can be improved. Note that FIG. 30A illustrates an example in which the pixel blocks 20 having the same dispersing direction of the spectroscopic element 160 are arranged, and FIG. 30B illustrates an example in which the pixel blocks 20 having different dispersing directions of the spectroscopic element 160 are arranged.

The configuration of the imaging apparatus 1 other than the above is similar to the configuration of the imaging apparatus 1 in the first embodiment of the present disclosure, and thus the description thereof will be omitted.

As described above, in the imaging apparatus 1 according to the ninth embodiment of the present disclosure, the spectroscopic element 160 is arranged in the pixel 100, and the on-chip lens 174 having the groove-shaped non-condensing region 175 parallel to the dispersing direction of the spectroscopic element 160 is arranged. Thus, the spectral ratio of the spectroscopic element 160 can be improved.

### (10. Tenth Embodiment)

In the imaging apparatus 1 of the fifth embodiment described above, the pixels 100a and 100b are separated by the isolation section 135. On the other hand, an imaging apparatus 1 according to a tenth embodiment of the present disclosure is different from the above-described fifth embodiment in that pixels 100a and 100b are isolated by means other than an isolation section 135.

### [Configuration of Pixel]

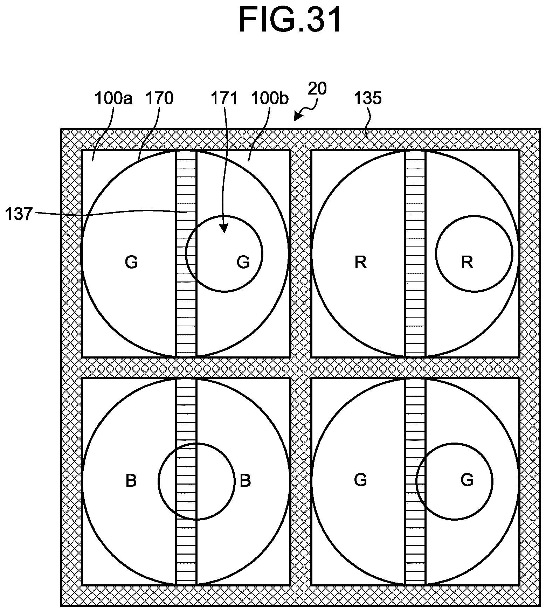

FIG. 31 is a diagram depicting a configuration example of a pixel block according to the tenth embodiment of the present disclosure. Similarly to FIG. 18, the drawing is a plan view depicting a configuration example of the pixel block 20. The pixel block 20 in the drawing is different from the pixel block 20 in FIG. 18 in that the pixels 100a and 100b are isolated by an isolation section 137.

The isolation section 137 is an isolation section including a semiconductor region having a relatively high impurity concentration. By isolating the pixels 100a and 100b using the isolation section 137, color mixture to the adjacent pixel 100 due to scattering can be reduced. This is because a member that scatters incident light such as the isolation section 135 can be reduced. Note that, similarly to FIG. 21, pupil correction is performed to shift the position of the on-chip lens 170 toward the central portion of the pixel region 3 in the peripheral edge portion of the pixel region 3. Furthermore, the non-condensing region 171 of the on-chip lens 170 is formed in a circular concave portion in plan view. Furthermore, the non-condensing region 171 of the on-chip lens 170 can be arranged to be shifted in the direction of the peripheral edge portion of the pixel region 3. At this time, the position of the non-condensing region 171 can be adjusted according to the color filter 150 of the pixel block 20 so as to adjust the light condensing range.

### [Configuration of On-Chip Lens]

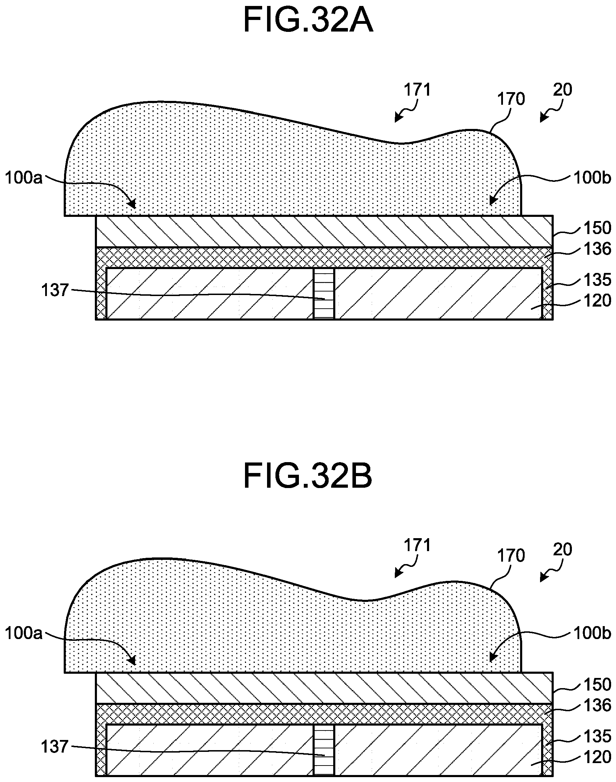

FIGS. 32A to 32C are diagrams depicting a configuration example of an on-chip lens according to the tenth embodiment of the present disclosure. The drawing is a cross-sectional view illustrating a configuration example of the on-chip lens 170 of the pixel block 20 in the peripheral edge portion of the pixel region 3. As described above, the on-chip lens 170 is arranged to be shifted in the direction of the central portion of the pixel region 3 by pupil correction.

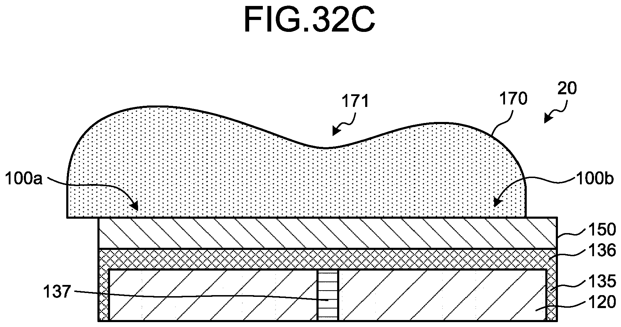

FIGS. 32A, 32B, and 32C are diagrams illustrating configuration examples of the on-chip lenses 170 of the pixel block 20 corresponding to red light, the pixel block 20 corresponding to green light, and the pixel block 20 corresponding to blue light, respectively.

As described above, the pixel block 20 in the drawing can adjust the position of the non-condensing region 171 of the on-chip lens 170 according to the wavelength that the color filter 150 corresponds to. The pixels 100a and 100b of the pixel block 20 constitute phase difference pixels. In this phase difference pixel, an error in phase difference detection occurs in a case where the isolation ratio, which is the ratio of the sensitivity to the incident angle of the incident light, is different in each pixel (the pixels 100a and 100b). In a case where the light condensing position of the on-chip lens 170 shifts from the boundary between the pixel 100a and the pixel 100b, a difference occurs in the respective isolation ratios. Therefore, in the pixel block 20 arranged at the peripheral edge portion of the pixel region 3, pupil correction is performed to compensate for the shift of the light condensing position.

However, in the semiconductor such as silicon (Si) constituting the photoelectric conversion element 101, the light absorption rate changes according to the wavelength. Specifically, short-wavelength light having a high absorption rate is absorbed in a shallow portion of the photoelectric conversion element 101, and long-wavelength light having a low absorption rate is absorbed in a deep portion of the photoelectric conversion element 101. Therefore, the light condensing position of incident light obliquely incident is shifted according to the wavelength of the incident light. Specifically, in a case where pupil correction of the on-chip lens 170 is performed on the basis of the incident light of the green light, the light condensing position of the red light reaching the deep portion of the photoelectric conversion element 101 is a position shifted to the far side in the oblique incident direction, and the absorption amount in the pixel 100 on the far side (the pixel 100b in FIG. 32A and the like) increases to cause a difference in the isolation ratio. On the other hand, the light condensing position of the blue light is shifted to the front side in the oblique incident direction (the side of the central portion of the pixel region 3), the absorption amount in the pixel 100 on the front side (the pixel 100a in FIG. 32A and the like) increases, and a difference occurs in the isolation ratio similarly to the red light.

Therefore, the pixel block 20 corresponding to the red light is condensed in the direction of the central portion of the pixel region 3 as compared with the pixel block 20 corresponding to the green light. That is, the pixel block 20 corresponding to the red light is condensed in the direction of the central portion of the pixel region 3. Specifically, as illustrated in FIG. 32A, the non-condensing region 171 is arranged to be shifted in the direction of the peripheral edge portion of the pixel region 3 so that the incident light is refracted at a steeper angle. On the other hand, the pixel block 20 corresponding to the blue light is condensed in the direction of the peripheral edge portion of the pixel region 3 as compared with the pixel block 20 corresponding to the green light. As illustrated in FIG. 32C, the non-condensing region 171 is arranged to be shifted to the central portion of the pixel region 3 such that the incident angle of the incident light is made shallow.

### [Another Configuration of Pixel]

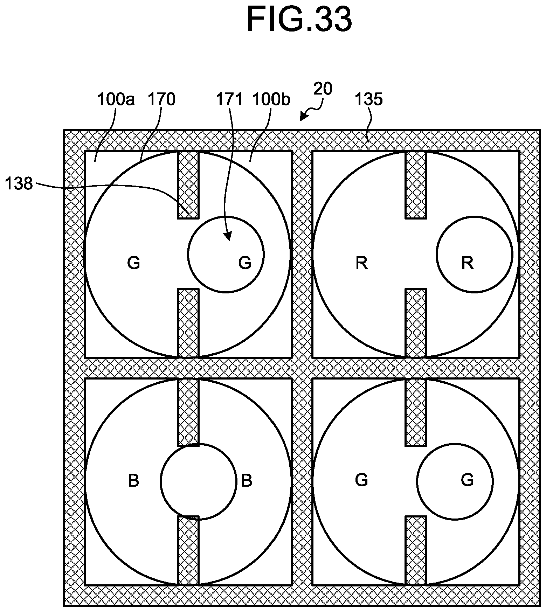

FIG. 33 is a diagram depicting another configuration example of the pixel block according to the tenth embodiment of the present disclosure. Similarly to FIG. 32, the drawing is a plan view depicting a configuration example of the pixel block 20. The pixel block 20 in the drawing is different from the pixel 100 in FIG. 32 in that the pixels 100a and 100b are isolated by an isolation section 138 having an opening in the central portion. The opening of the isolation section 138 constitutes an overflow path between the pixels 100a and 100b. Other configurations of the pixel block 20 are similar to those of the pixel block 20 in FIG. 32, and thus, description thereof is omitted.

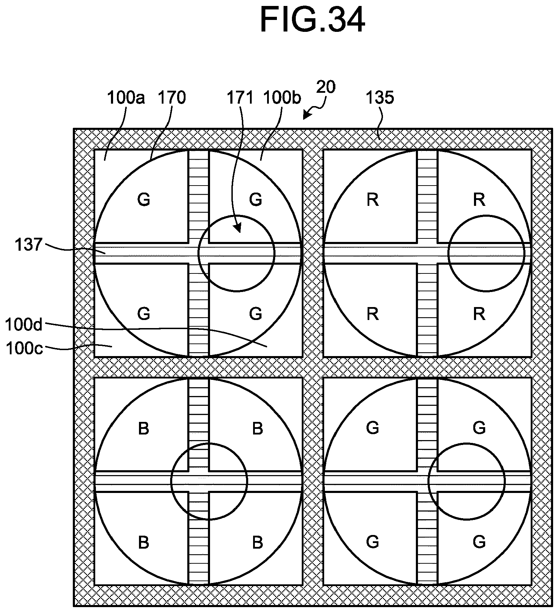

Note that the configuration of the pixel block 20 in FIGS. 31 and 33 can be applied to the pixel block 20 in FIG. 2. This example will be described with reference to FIGS. 34 and 35.

### [Another Configuration of Pixel]

FIG. 34 is a diagram depicting another configuration example of the pixel block according to the tenth embodiment of the present disclosure. The drawing depicts an example in which the pixels 100a to 100d constituting the pixel block 20 are isolated by the isolation section 137. The isolation section 137 in the drawing is formed in a cross shape in plan view and isolates the pixels 100a to 100d.

FIG. 35 is a diagram depicting another configuration example of the pixel block according to the tenth embodiment of the present disclosure. The drawing depicts an example in which the pixels 100a to 100d constituting the pixel block 20 are isolated by two orthogonal isolation sections 138.

The configurations of the on-chip lens 170 and the non-condensing region 171 of the pixel block 20 in FIGS. 34 and 35 can adopt the same configurations as those of the on-chip lens 170 and the non-condensing region 171 in FIG. 32.

### (11. Eleventh Embodiment)

Variations of the on-chip lens 170 will be described.

### [Configuration of Pixel]

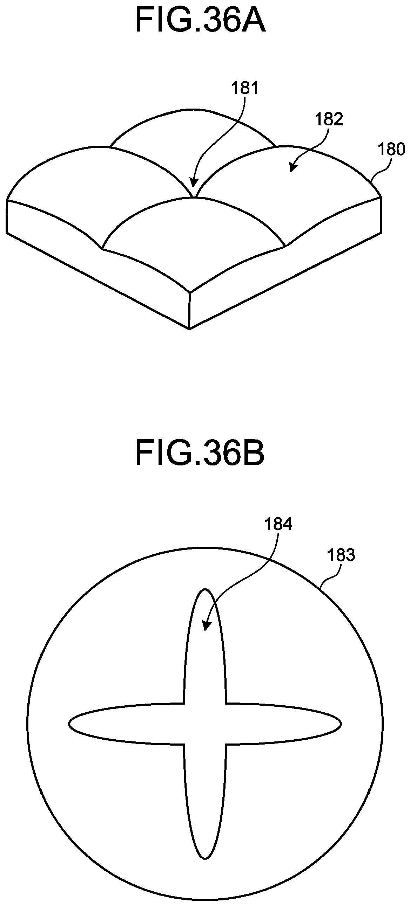

FIGS. 36A and 36B are diagrams depicting a configuration example of an on-chip lens according to an eleventh embodiment of the present disclosure. FIG. 36A illustrates an example of an on-chip lens 180 including four convex portions 182 and a non-condensing region 181. FIG. 36B illustrates an example of the on-chip lens 183 having a non-condensing region 184 formed in a circular shape in plan view and having a cross shape.

Note that the configuration of the second modification of the first embodiment of the present disclosure can be applied to other embodiments. Specifically, the non-condensing region 172 in FIG. 10 can be applied to the second to fifth embodiments of the present disclosure.

The configuration of the second embodiment of the present disclosure can be applied to other embodiments. Specifically, the on-chip lens 173 in FIG. 11 can be applied to the third and fourth embodiments of the present disclosure.

### (12. Configuration Example of Imaging Apparatus)

The imaging apparatus 1 as described above can be applied to various electronic devices, such as an imaging system such as a digital still camera or a digital video camera, a mobile phone having an imaging function, or another device having an imaging function, for example.

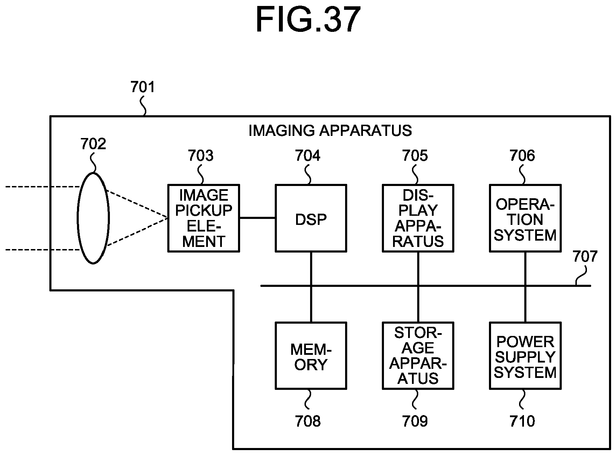

FIG. 37 is a block diagram depicting a configuration example of an imaging apparatus mounted on an electronic device. The drawing is a block diagram illustrating a configuration example of an imaging apparatus 701.

As depicted in FIG. 37, the imaging apparatus 701 includes an imaging lens 702, an image pickup element 703, and a digital signal processor (DSP) 704. The DSP 704, a display apparatus 705, an operation system 706, a memory 708, a recording apparatus 709, and a power supply system 710 are connected via a bus 707, and can capture a still image and a moving image.

The imaging lens 702 includes one or a plurality of lenses, guides image light from a subject (incident light) to the image pickup element 703, and forms an image on a light receiving surface (sensor unit) of the image pickup element 703.

As the image pickup element 703, the imaging apparatus 1 of any of the above-described configuration examples is applied. Electrons are accumulated in the image pickup element 703 for a certain period according to an image formed on the light receiving surface via the imaging lens 702. Then, a signal corresponding to the electrons accumulated in the image pickup element 703 is input to the DSP 704.

The DSP 704 performs various types of signal processing on the signal from the image pickup element 703 to acquire an image, and temporarily stores data of the image in the memory 708. The image data stored in the memory 708 is recorded in the recording apparatus 709 or supplied to the display apparatus 705 to display an image. Furthermore, the operation system 706 receives various operations by the user and supplies an operation signal to each block of the imaging apparatus 701, and the power supply system 710 supplies power necessary for driving each block of the imaging apparatus 701.

### (13. Application Example to Mobile Body)

The technology according to the present disclosure (present technology) can be applied to various products. For example, the technology according to the present disclosure may be realized as devices mounted on any types of mobile bodies such as automobiles, electric vehicles, hybrid electric vehicles, motorcycles, bicycles, personal mobilities, airplanes, drones, ships, and robots.

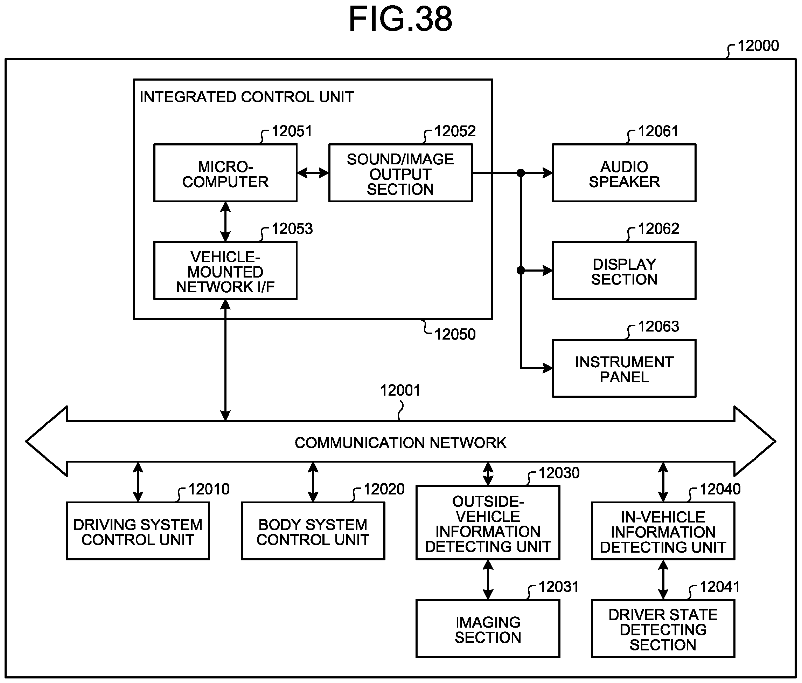

FIG. 38 is a block diagram depicting an example of schematic configuration of a vehicle control system as an example of a mobile body control system to which the technology according to an embodiment of the present disclosure can be applied.

A vehicle control system 12000 includes a plurality of electronic control units connected to each other via a communication network 12001. In the example depicted in FIG. 38, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 38, an audio speaker 12061, a display section 12062, and an instrument panel 12063 are illustrated as the output device. The display section 12062 may, for example, include at least one of an on-board display and a head-up display.

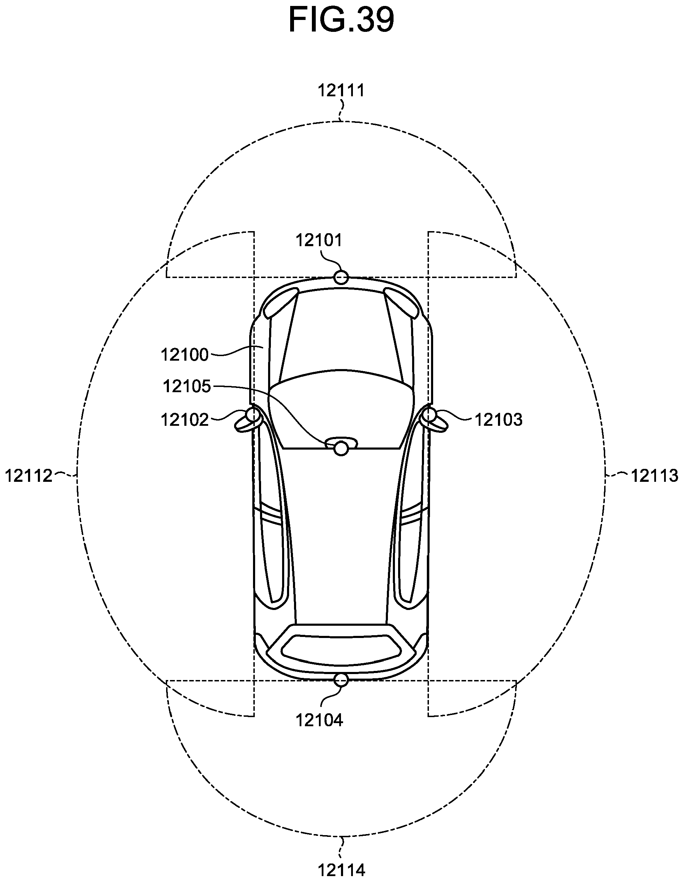

FIG. 39 is a diagram depicting an example of the installation position of the imaging section 12031.

In FIG. 39, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of a vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 39 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the above, an example of the vehicle control system to which the technology related to the present disclosure can be applied is described. The technology according to the present disclosure can be applied to the imaging section 12031 within the above-described configuration. Specifically, the imaging apparatus 1 in FIG. 1 can be applied to the imaging section 12031.

### (14. Application Example to Endoscopic Surgery System)

The technology according to the present disclosure (present technology) can be applied to various products. For example, the technology according to the present disclosure may be applied to an endoscopic surgery system.

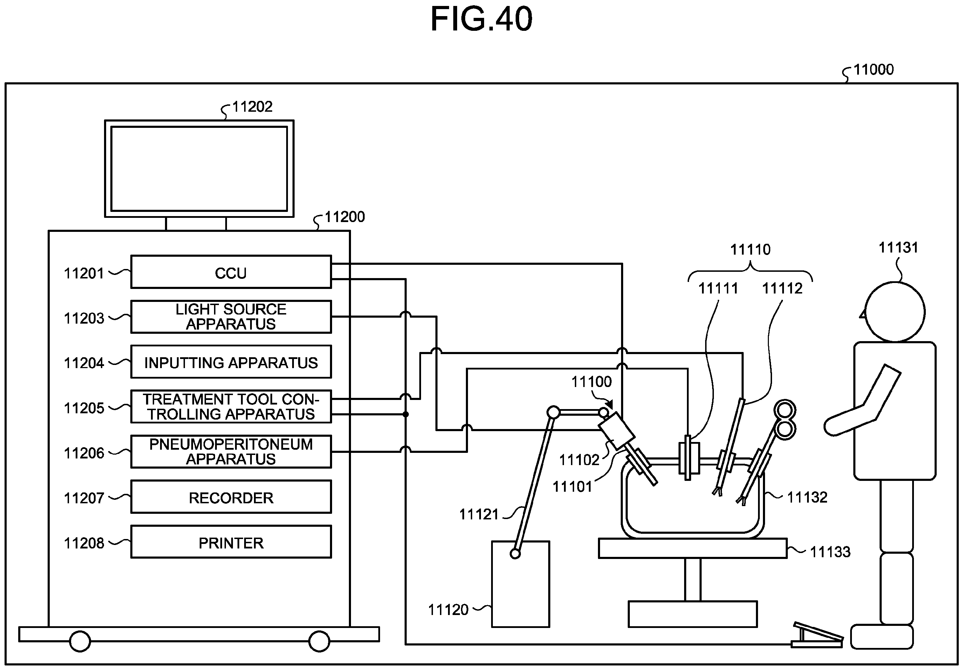

FIG. 40 is a view depicting an example of a schematic configuration of an endoscopic surgery system to which the technology according to an embodiment of the present disclosure (present technology) can be applied.

In FIG. 40, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

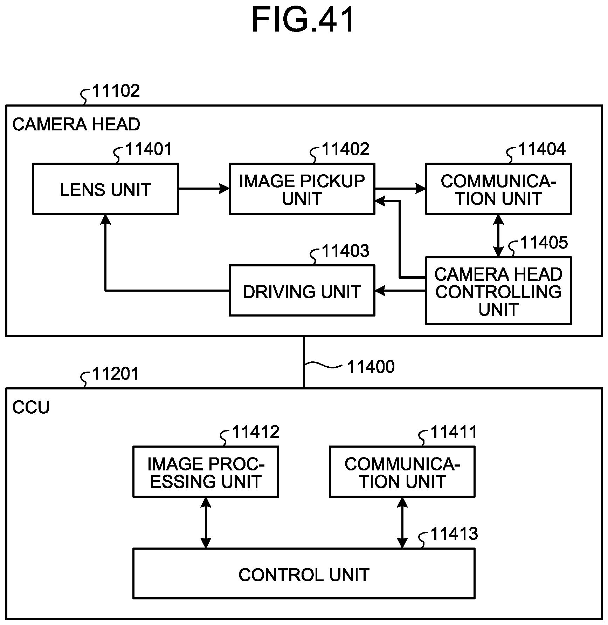

FIG. 41 is a block diagram depicting an example of a functional configuration of the camera head 11102 and the CCU 11201 depicted in FIG. 40.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

In the above, an example of the endoscopic surgery system to which the technology related to the present disclosure can be applied is described. The technology according to the present disclosure can be applied to the endoscope 11100, the image pickup unit 11402 of the camera head 11102 within the above-described configuration. Specifically, the imaging apparatus 1 in FIG. 1 can be applied to the image pickup unit 11402.

Note that, here, the endoscopic surgery system has been described as an example, but the technology according to the present disclosure may be applied to, for example, a microscopic surgery system or the like.

Furthermore, the effects described in the present specification are merely examples and are not limited, and other effects may be provided.

### (Effects)

The imaging apparatus 1 includes the plurality of pixels 100 and the on-chip lens 170. The pixel 100 performs photoelectric conversion of incident light from a subject to generate an image signal. The on-chip lens 170 is arranged in common in the plurality of pixels 100, includes the non-condensing region 171 in the central portion, and condenses the incident light on the plurality of pixels 100 in the peripheral portion. As a result, the light condensing range of the incident light can be widened.

In addition, the on-chip lens 170 may include a non-condensing region 171 including a concave portion.

Furthermore, the on-chip lens 170 may include a non-condensing region 171 including a region with a surface curvature smaller than that of the peripheral portion.

Furthermore, the on-chip lens 170 may include the non-condensing region 172 including a region with a flat surface.

Furthermore, the on-chip lens (on-chip lens 173) may include a peripheral portion whose thickness is adjusted according to the incident direction of the incident light. As a result, the light condensing range of the incident light can be adjusted.

Furthermore, the plurality of pixels 100 may be four pixels 100 arranged in 2 rows and 2 columns.

Furthermore, the plurality of pixels 100 may be two adjacent pixels 100.

In addition, two adjacent pixels 100 among the plurality of pixels 100 may generate, as image signals, a plurality of phase difference signals for pupil division of a subject and detection of an image plane phase difference. Thus, the focal position of the subject can be detected.

Furthermore, the on-chip lens (on-chip lens 174) may include the non-condensing region 175 including a groove-shaped concave portion formed in a direction orthogonal to the direction of pupil division.

Furthermore, the pixel region 3 including the plurality of pixel blocks 20 including the plurality of pixels 100 and the on-chip lens 170 arranged in common in the plurality of pixels 100 is included, and the pixel block 20 may be arranged with the color filter 150 that transmits incident light of the same wavelength in the plurality of pixels 100 of the pixel block 20.

Furthermore, the pixel region 3 may further include the second pixel block 30 including the plurality of pixels 100 and the second on-chip lens 179 that is arranged in common in the plurality of pixels 100 to condense the incident light, and being arranged with the color filter 150 that transmits incident light of the same wavelength in the plurality of pixels 100. As a result, the light condensing range of the incident light can be adjusted according to the type of the color filter 150.

In addition, the second pixel block 30 may generate, as image signals, a plurality of phase difference signals for two adjacent pixels 100 among the plurality of pixels 100 of the second pixel block 30 to pupil divide a subject and detect of an image plane phase difference.

Furthermore, in the second pixel block 30, a color filter 150 that transmits green light may be arranged in a plurality of pixels 100 of the second pixel block 30. As a result, the light condensing range of the incident light can be narrowed in the pixel that detects the phase difference signal.

Furthermore, in the second pixel block 30, a color filter 150 that transmits long-wavelength light may be arranged in a plurality of pixels 100 of the second pixel block 30. As a result, the configuration of the second pixel block 30 in which the color filters 150 that transmit long-wavelength light are arranged can be simplified.

Furthermore, in the pixel region 3, the second pixel block 30 may be arranged in the central portion, and the pixel block 20 may be arranged in the peripheral edge portion. As a result, it is possible to adjust the light condensing range according to the incident angle of the incident light.

Furthermore, in the pixel region 3, the on-chip lens 170 may be arranged to be shifted for each pixel block 20 according to the incident angle of the incident light. As a result, it is possible to adjust the light condensing position according to the incident angle of the incident light.

The electronic device is an electronic device including the plurality of pixels 100 that performs photoelectric conversion of incident light from a subject to generate an image signal, the on-chip lens 170 that is arranged in common in the plurality of pixels 100, includes a non-condensing region in a central portion, and condenses the incident light on the plurality of pixels 100 in a peripheral portion, and the column signal processing circuit 5 that processes the generated image signal. The light condensing range of the incident light can be widened.

Furthermore, the effects described in the present specification are merely examples and are not limited, and other effects may be provided.

Note that the present technology can also have the following configurations.
(1) An imaging apparatus comprising:
   a plurality of pixels that performs photoelectric conversion of incident light from a subject to generate an image signal; and
   an on-chip lens that is arranged in common in the plurality of pixels, includes a non-condensing region in a central portion, and condenses the incident light on the plurality of pixels in a peripheral portion.
(2) The imaging apparatus according to the above (1), wherein the on-chip lens includes the non-condensing region including a concave portion.
(3) The imaging apparatus according to the above (2), wherein the on-chip lens includes the concave portion in which an opening is adjusted according to an incident angle of the incident light.
(4) The imaging apparatus according to the above (3), wherein the on-chip lens includes the concave portion in which a size of the opening is adjusted according to an incident angle of the incident light.
(5) The imaging apparatus according to the above (3), wherein the on-chip lens includes the concave portion in which a position of the opening is adjusted according to an incident angle of the incident light.
(6) The imaging apparatus according to any one of the above (1) to (5), wherein the on-chip lens includes the non-condensing region including a region with a surface curvature smaller than that of the peripheral portion.
(7) The imaging apparatus according to any one of the above (1) to (5), wherein the on-chip lens includes the non-condensing region including a region with a flat surface.
(8) The imaging apparatus according to any one of the above (1) to (7), wherein the on-chip lens includes the peripheral portion whose thickness is adjusted according to an incident direction of the incident light.
(9) The imaging apparatus according to any one of the above (1) to (8), wherein the plurality of pixels is four pixels arranged in two rows and two columns.
(10) The imaging apparatus according to any one of the above (1) to (8), wherein the plurality of pixels is two adjacent pixels.
(11) The imaging apparatus according to any one of the above (1) to (10), wherein the two adjacent pixels among the plurality of pixels generate, as the image signal, a plurality of phase difference signals for pupil division of the subject and detection of an image plane phase difference.
(12) The imaging apparatus according to the above (11), wherein the on-chip lens includes the non-condensing region including a groove-shaped concave portion formed in a direction orthogonal to a direction of the pupil division.
(13) The imaging apparatus according to any one of the above (1) to (12), comprising
   a pixel region including a plurality of pixel blocks including the plurality of pixels and the on-chip lens arranged in common in the plurality of pixels, wherein
   the pixel block is arranged with a color filter that transmits incident light of the same wavelength in the plurality of pixels of the pixel block.
(14) The imaging apparatus according to the above (13), wherein the pixel region includes the plurality of pixels and a second on-chip lens arranged in common in the plurality of pixels to condense the incident light, and further includes a second pixel block arranged with a color filter that transmits incident light of the same wavelength in the plurality of pixels.
(15) The imaging apparatus according to the above (14), wherein the second pixel block generates, as the image signal, a plurality of phase difference signals for the two adjacent pixels among the plurality of pixels of the second pixel block to pupil divide the subject and detect an image plane phase difference.
(16) The imaging apparatus according to the above (15), wherein the second pixel block is arranged with the color filter that transmits green light in the plurality of pixels of the second pixel block.
(17) The imaging apparatus according to the above (13) or (15), wherein the second pixel block is arranged with the color filter that transmits a long wavelength light in the plurality of pixels of the second pixel block.
(18) The imaging apparatus according to any one of the above (14) to (17), wherein the pixel region is arranged with the second pixel block in a central portion, and is arranged with the pixel block in a peripheral edge portion.
(19) The imaging apparatus according to any one of the above (13) to (18), wherein the pixel region is arranged with the on-chip lens to be shifted according to an incident angle of incident light for each of the pixel blocks.
(20) The imaging apparatus according to the above (13), wherein the pixel region includes a pixel unit including a plurality of the pixel blocks including the color filter that transmits incident light of same wavelength.
(21) The imaging apparatus according to the above (20), wherein the pixel region includes the pixel unit in which the non-condensing region of the on-chip lens of each of the pixel blocks is arranged at a position shifted in a direction outside the pixel unit containing the pixel blocks.
(22) The imaging apparatus according to the above (20), wherein
   the pixel region includes a plurality of the pixel units in which the color filter that transmits incident light of different wavelength is arranged, and
   at least one of the plurality of pixel units each arranged with the color filter that transmits the incident light of the different wavelength includes the on-chip lens in which the non-condensing region is arranged at a position shifted in a direction inside the pixel unit containing the non-condensing region.
(23) The imaging apparatus according to the above (13), wherein, in the pixel region, a plurality of the pixel blocks including two of the pixels adjacent in a row direction and including the color filter that transmits incident light of a same wavelength and the on-chip lens arranged in common in the pixels is arranged in a matrix direction, and the pixel blocks are arranged to be shifted by the pixels for each row.
(24) The imaging apparatus according to the above (23), wherein, in the pixel region, a plurality of pixel groups is arranged in the matrix direction, the plurality of pixel groups each including a multi-pixel portion that is the two pixel blocks adjacent in the row direction including the color filter that transmits incident light of the same wavelength, and a single pixel portion that is the pixel block including the color filter that transmits incident light of a wavelength different from that of the color filter of the multi-pixel portion and adjacent in the row direction to the multi-pixel portion.
(25) The imaging apparatus according to the above (24), wherein the pixel group includes the single pixel portion including the on-chip lens including the non-condensing region of size different from the non-condensing region of the each on-chip lens of the multi-pixel portion.
(26) The imaging apparatus according to the above (24), wherein the pixel group includes the multi-pixel portion including the pixel blocks, each including the on-chip lens including the non-condensing region formed in different sizes.
(27) The imaging apparatus according to the above (1), further comprising
   a spectroscopic element that is arranged in common in the plurality of pixels and performs dispersing the incident light in a predetermined wavelength range, wherein
   the on-chip lens includes the non-condensing region of a groove-shaped concave portion substantially parallel to a direction of the dispersing.
(28) An electronic device comprising:
   a plurality of pixels that performs photoelectric conversion of incident light from a subject to generate an image signal;
   an on-chip lens that is arranged in common in the plurality of pixels, includes a non-condensing region in a central portion, and condenses the incident light on the plurality of pixels in a peripheral portion; and
   a processing circuit that processes the generated image signal.

### Reference Signs List

1, 701 IMAGING APPARATUS
3 PIXEL REGION
5 COLUMN SIGNAL PROCESSING CIRCUIT
20 PIXEL BLOCK
30 SECOND PIXEL BLOCK
40 PIXEL GROUP
41 MULTI-PIXEL PORTION
42 SINGLE PIXEL PORTION
50 PIXEL UNIT
100, 100a, 100b, 100c, 100d PIXEL
101 PHOTOELECTRIC CONVERSION ELEMENT
120 SEMICONDUCTOR SUBSTRATE
135, 137, 138 ISOLATION SECTION
150 COLOR FILTER
160 SPECTROSCOPIC ELEMENT
170, 173, 174, 176, 177, 180, 183 ON-CHIP LENS
171, 172, 175, 178, 181, 184 NON-CONDENSING REGION
179 SECOND ON-CHIP LENS
300 PIXEL BLOCK REGION
702 IMAGING LENS
703 IMAGE PICKUP ELEMENT
11402, 12031, 12101 to 12105 IMAGE PICKUP UNIT, IMAGING SECTION

## Claims

1. An imaging apparatus comprising:
a plurality of pixels that performs photoelectric conversion of incident light from a subject to generate an image signal; and
an on-chip lens that is arranged in common in the plurality of pixels, includes a non-condensing region in a central portion, and condenses the incident light on the plurality of pixels in a peripheral portion.

2. The imaging apparatus according to claim 1, wherein the on-chip lens includes the non-condensing region including a concave portion.

3. The imaging apparatus according to claim 2, wherein the on-chip lens includes the concave portion in which an opening is adjusted according to an incident angle of the incident light.

4. The imaging apparatus according to claim 3, wherein the on-chip lens includes the concave portion in which a size of the opening is adjusted according to an incident angle of the incident light.

5. The imaging apparatus according to claim 3, wherein the on-chip lens includes the concave portion in which a position of the opening is adjusted according to an incident angle of the incident light.

6. The imaging apparatus according to claim 1, wherein the on-chip lens includes the non-condensing region including a region with a surface curvature smaller than that of the peripheral portion.

7. The imaging apparatus according to claim 1, wherein the on-chip lens includes the non-condensing region including a region with a flat surface.

8. The imaging apparatus according to claim 1, wherein the on-chip lens includes the peripheral portion whose thickness is adjusted according to an incident direction of the incident light.

9. The imaging apparatus according to claim 1, wherein the plurality of pixels is four pixels arranged in two rows and two columns.

10. The imaging apparatus according to claim 1, wherein the plurality of pixels is two adjacent pixels.

11. The imaging apparatus according to claim 1, wherein the two adjacent pixels among the plurality of pixels generate, as the image signal, a plurality of phase difference signals for pupil division of the subject and detection of an image plane phase difference.

12. The imaging apparatus according to claim 11, wherein the on-chip lens includes the non-condensing region including a groove-shaped concave portion formed in a direction orthogonal to a direction of the pupil division.

13. The imaging apparatus according to claim 1, comprising
a pixel region including a plurality of pixel blocks including the plurality of pixels and the on-chip lens arranged in common in the plurality of pixels, wherein
the pixel block is arranged with a color filter that transmits incident light of the same wavelength in the plurality of pixels of the pixel block.

14. The imaging apparatus according to claim 13, wherein the pixel region further includes a second pixel block that includes the plurality of pixels and a second on-chip lens arranged in common in the plurality of pixels to condense the incident light, and the second pixel block is arranged with a color filter that transmits incident light of the same wavelength in the plurality of pixels.

15. The imaging apparatus according to claim 14, wherein the second pixel block generates, as the image signal, a plurality of phase difference signals for the two adjacent pixels among the plurality of pixels of the second pixel block to pupil divide the subject and detect an image plane phase difference.

16. The imaging apparatus according to claim 15, wherein the second pixel block is arranged with the color filter that transmits green light in the plurality of pixels of the second pixel block.

17. The imaging apparatus according to claim 14, wherein the second pixel block is arranged with the color filter that transmits a long wavelength light in the plurality of pixels of the second pixel block.

18. The imaging apparatus according to claim 14, wherein the pixel region is arranged with the second pixel block in a central portion, and is arranged with the pixel block in a peripheral edge portion.

19. The imaging apparatus according to claim 13, wherein the pixel region is arranged with the on-chip lens to be shifted according to an incident angle of incident light for each of the pixel blocks.

20. The imaging apparatus according to claim 13, wherein the pixel region includes a pixel unit including a plurality of the pixel blocks including the color filter that transmits incident light of same wavelength.

21. The imaging apparatus according to claim 20, wherein the pixel region includes the pixel unit in which the non-condensing region of the on-chip lens of each of the pixel blocks is arranged at a position shifted in a direction outside the pixel unit containing the non-condensing region.

22. The imaging apparatus according to claim 20, wherein
the pixel region includes a plurality of the pixel units in which the color filter that transmits incident light of different wavelength is arranged respectively, and
at least one of the plurality of pixel units each arranged with the color filter that transmits the incident light of the different wavelength includes the on-chip lens in which the non-condensing region is arranged at a position shifted in a direction inside the pixel unit containing the non-condensing region.

23. The imaging apparatus according to claim 13, wherein, in the pixel region, a plurality of the pixel blocks including two of the pixels adjacent in a row direction and including the color filter that transmits incident light of a same wavelength and the on-chip lens arranged in common in the pixels is arranged in a matrix direction, and the pixel blocks are arranged to be shifted by the pixels for each row.

24. The imaging apparatus according to claim 23, wherein, in the pixel region, a plurality of pixel groups is arranged in the matrix direction, the plurality of pixel groups each including a multi-pixel portion that is the two pixel blocks adjacent in the row direction including the color filter that transmits incident light of the same wavelength, and a single pixel portion that is the pixel block including the color filter that transmits incident light of a wavelength different from that of the color filter of the multi-pixel portion and adjacent in the row direction to the multi-pixel portion.

25. The imaging apparatus according to claim 24, wherein the pixel group includes the single pixel portion including the on-chip lens including the non-condensing region of size different from the non-condensing region of the each on-chip lens of the multi-pixel portion.

26. The imaging apparatus according to claim 24, wherein the pixel group includes the multi-pixel portion including the pixel blocks, each including the on-chip lens including the non-condensing region formed in different sizes.

27. The imaging apparatus according to claim 1, further comprising
a spectroscopic element that is arranged in common in the plurality of pixels and performs dispersing the incident light in a predetermined wavelength range, wherein
the on-chip lens includes the non-condensing region of a groove-shaped concave portion substantially parallel to a direction of the dispersing.

28. An electronic device comprising:
a plurality of pixels that performs photoelectric conversion of incident light from a subject to generate an image signal;
an on-chip lens that is arranged in common in the plurality of pixels, includes a non-condensing region in a central portion, and condenses the incident light on the plurality of pixels in a peripheral portion; and
a processing circuit that processes the generated image signal.
